# EUROPEAN PATENT APPLICATION

(11) **EP 4 561 302 A1**
(43) Date of publication of application: **28.05.2025**
(21) Application number: 24209671.7
(22) Date of filing: 30.10.2024
(51) Int. Cl.: H10F 39/10, H10F 39/18, H10F 39/00

(54) **PHOTOELECTRIC CONVERSION APPARATUS AND EQUIPMENT**

(30) Priority: 24.11.2023 JP 2023199235; 29.08.2024 JP 2024147403
(71) Applicant: Canon Kabushiki Kaisha, Ohta-ku Tokyo 146-8501 (JP)
(72) Inventor: SHINOHARA, Mahito, Tokyo (JP)
(74) Representative: WESER & Kollegen Patentanwälte PartmbB

(57) **Abstract**

An apparatus in which a photoelectric conversion unit is disposed on a semiconductor substrate including a first surface and a second surface on the opposite side of the first surface includes a first region of a first conductivity type constituting a part of the first surface and connected to a detection circuit configured to detect avalanche breakdown, a second region of the first conductivity type disposed away from the first region, a third region of a second conductivity type opposite to the first conductivity type, the third region disposed at a position closer to the second surface than the first and second regions, and a fourth region disposed between the first and second regions. The second and third regions function as an avalanche photodiode. The first and second regions are configured to be conductive with each other via the fourth region.

## Description

### BACKGROUND

### Technical Field

The present disclosure relates to a photoelectric conversion apparatus and an equipment.

### Description of the Related Art

Single-photon avalanche diode (SPAD) is known as a photon counting device using avalanche multiplication. Japanese Patent Application Laid-Open No. 2018-064086 discusses a photodetector having a pixel including an avalanche photodiode (APD) that functions as SPAD.

The charge multiplication factor of the APD is considered. In the SPAD, generally, voltage obtained by adding an excess bias Vex to a breakdown voltage Vbd is applied between the cathode and the anode of the APD, and avalanche breakdown is detected based on a change (a decrease) in the potential of the cathode when avalanche current flows. If the cathode capacitance of the APD is Cc, and the amount of change in the potential of the cathode when avalanche breakdown occurs is ΔV, the amount of charge discharged from the cathode by the avalanche breakdown is represented by Cc × ΔV. If elementary charge is qe, the number of electron-hole pairs generated by avalanche breakdown, i.e., the carrier multiplication factor, is represented by Cc × ΔV/qe. The charge multiplication factor and the carrier multiplication factor are the same, and therefore will hereinafter be referred to simply as the "multiplication factor". The cathode capacitance Cc, in which the main component comes from a wiring pattern connected to the cathode or a detection circuit for detecting avalanche breakdown, is about 8 fF, for example. If the amount of change ΔV in the potential of the cathode when avalanche breakdown is detected is ΔV = 2.4 V, which is comparable with the excess bias Vex, the multiplication factor is one hundred twenty thousand. With the high multiplication factor, it is possible to detect weak light at a single-photon level, while the following issue also arises.

Many carriers generated by the avalanche breakdown flow between the anode and the cathode to which the breakdown voltage Vbd is applied. Thus, much energy is consumed by a great current flowing by the incidence of a single photon. If many pixels are disposed and the number of incident photons is great, consumption energy increases so much.

### SUMMARY

According to a first aspect of the present invention, there is provided a photoelectric conversion apparatus as specified in claims 1 to 21. According to a second aspect of the present invention, there is provided a photoelectric conversion apparatus as specified in claims 4 to 21. According to a third aspect of the present invention, there is provided a device as specified in claim 22.

Further features of the disclosure will become apparent from the following description of exemplary embodiments with reference to the attached drawings.

### BRIEF DESCRIPTION OF THE DRAWINGS

Fig. 1 is a diagram illustrating an example of a configuration of a photoelectric conversion apparatus according to the present exemplary embodiments.
Fig. 2 is a block diagram illustrating an example of a configuration of a pixel of the photoelectric conversion apparatus in Fig. 1.
Fig. 3A is a diagram illustrating an example of an operation of the pixel of the photoelectric conversion apparatus in Fig. 2.
Fig. 3B is a diagram illustrating the example of the operation of the pixel of the photoelectric conversion apparatus in Fig. 2.
Fig. 4A is a diagram illustrating an example of an operation of the pixel of the photoelectric conversion apparatus in Fig. 2.
Fig. 4B is a diagram illustrating the example of the operation of the pixel of the photoelectric conversion apparatus in Fig. 2.
Fig. 5 is a plan view illustrating examples of configurations of an avalanche photodiode (APD) and a photodiode (PD) of the pixel of the photoelectric conversion apparatus in Fig. 1.
Fig. 6 is a cross-sectional view illustrating the examples of the configurations of the APD and the PD in Fig. 5.
Fig. 7A is a diagram illustrating an equivalent circuit diagram of the pixel in Fig. 5.
Fig. 7B is a diagram illustrating an example of an operation of the pixel in Fig. 5.
Fig. 8 is a plan view illustrating examples of the configurations of the APD and the PD of the pixel of the photoelectric conversion apparatus in Fig. 1.
Fig. 9 is a cross-sectional view illustrating examples of the configurations of the APD and the PD in Fig. 5.
Fig. 10 is a plan view illustrating examples of the configurations of the APD and the PD of the pixel of the photoelectric conversion apparatus in Fig. 1.
Fig. 11 is a cross-sectional view illustrating the examples of the configurations of the APD and the PD in Fig. 10.
Fig. 12 is a cross-sectional view illustrating variations of the APD and the PD in Fig. 11.
Fig. 13 is a cross-sectional view illustrating examples of the configurations of the APD and the PD of the pixel of the photoelectric conversion apparatus in Fig. 1.
Fig. 14 is a cross-sectional view illustrating examples of the configurations of the APD and the PD of the pixel of the photoelectric conversion apparatus in Fig. 1.
Fig. 15 is a cross-sectional view illustrating examples of the configurations of the APD and the PD of the pixel of the photoelectric conversion apparatus in Fig. 1.
Fig. 16 is a diagram illustrating a part of a method for manufacturing the pixel in Fig. 15.
Fig. 17 is a cross-sectional view illustrating examples of the configurations of the APD and the PD of the pixel of the photoelectric conversion apparatus in Fig. 1.
Fig. 18 is a diagram illustrating a part of a method for manufacturing the pixel in Fig. 17.
Fig. 19 is a diagram illustrating distributions of impurity ions in a depth direction of a semiconductor substrate in regions of the pixel in Fig. 17.
Fig. 20 is an equivalent circuit diagram illustrating an example of the configuration of the pixel of the photoelectric conversion apparatus in Fig. 1.
Fig. 21 is a plan view illustrating examples of the configurations of the APD and the PD of the pixel of the photoelectric conversion apparatus in Fig. 1.
Fig. 22 is a cross-sectional view illustrating the examples of the configurations of the APD and the PD in Fig. 21.
Fig. 23A is a diagram illustrating an equivalent circuit diagram of the pixel in Fig. 21.
Fig. 23B is a diagram illustrating an example of an operation of the pixel in Fig. 21.
Fig. 24 is an equivalent circuit diagram illustrating an example of the configuration of the pixel of the photoelectric conversion apparatus in Fig. 1.
Fig. 25 is a diagram illustrating an example of an operation of the pixel in Fig. 24.
Fig. 26 is a diagram illustrating an example of a configuration of an equipment into which the photoelectric conversion apparatus according to the present exemplary embodiments is incorporated.

### DESCRIPTION OF THE EMBODIMENTS

Exemplary embodiments will be described in detail below with reference to the attached drawings. The following exemplary embodiments do not limit the disclosure according to the appended claims. Although a plurality of features is described in the exemplary embodiments, not all the plurality of features is essential for the disclosure, and the plurality of features may be optionally combined together. Further, in the attached drawings, the same or similar components are designated by the same reference numbers, and are not redundantly described.

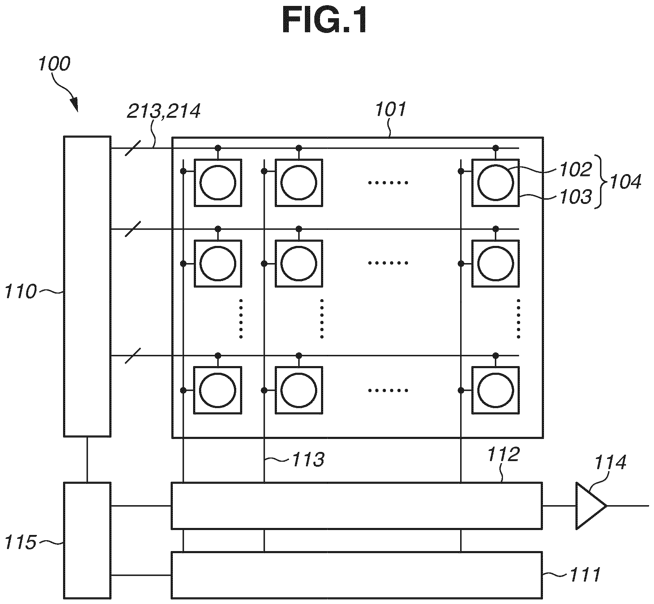

With reference to Figs. 1 to 26, a photoelectric conversion apparatus according to exemplary embodiments of the present disclosure is described. Each of the following exemplary embodiments illustrates an example of the present disclosure, and does not limit the disclosure according to the appended claims. In the following exemplary embodiments, signal charge carriers are electrons, and single-photon avalanche diode (SPAD) that detects the potential change of the cathode by the avalanche current is described. Thus, a semiconductor region of a first conductivity type where the majority carriers are electros is an N-type semiconductor region, and a semiconductor region of a second conductivity type opposite to the first conductivity type is a P-type semiconductor region. However, holes may be signal charge carriers, or a configuration may be employed in which a change in the potential of the anode is detected. In this case, a semiconductor region of the first conductivity type where the majority carriers are holes is a P-type semiconductor region, and a semiconductor region of the second conductivity type opposite to the first conductivity type is an N-type semiconductor region.

First, with reference to Fig. 1, the photoelectric conversion apparatus applicable to the exemplary embodiments of the present disclosure is described based on a general SPAD operation. Fig. 1 is a block diagram illustrating an example of the configuration of a photoelectric conversion apparatus 100 according to the present exemplary embodiments. The photoelectric conversion apparatus 100 includes a pixel array 101, a control pulse generation circuit 115, a horizontal scanning circuit 111, a reading circuit 112, a vertical scanning circuit 110, signal lines 113, and driving lines 213 and 214. In the pixel array 101, a plurality of pixels 104 is disposed in a matrix. Each pixel 104 can include a photoelectric conversion unit 102 including an avalanche photodiode (APD) and a signal processing circuit 103. The photoelectric conversion unit 102 converts light into an electric signal. The signal processing circuit 103 outputs the electric signal obtained by the conversion to the reading circuit 112.

The vertical scanning circuit 110 receives control pulses supplied from the control pulse generation circuit 115 and supplies the control pulses to the pixels 104. As the vertical scanning circuit 110, a logic circuit such as a shift register or an address decoder is used.

A signal output from the photoelectric conversion unit 102 of each pixel 104 is processed by the signal processing circuit 103. For example, in the signal processing circuit 103, a counter and a memory are provided. The memory holds a digital value.

To read signals from memories of the pixels 104 holding digital signals, the horizontal scanning circuit 111 inputs control pulses for sequentially selecting columns to the signal processing circuits 103. To the signal lines 113, signals are output from the signal processing circuits 103 of pixels 101 selected by the vertical scanning circuit 110 in a selected column. The signals output to the signal lines 113 are output to a recording apparatus or a signal processing apparatus disposed outside the photoelectric conversion apparatus 100 via an output circuit 114.

In the configuration illustrated in Fig. 1, the pixels 104 are two-dimensionally disposed in the pixel array 101. The aspect of the embodiments, however, is not limited to this. The pixels 104 may be one-dimensionally disposed in the pixel array 101. The functions of the signal processing circuits 103 do not necessarily need to be provided corresponding one by one to all the pixels 104, and for example, a single signal processing circuit 103 may be shared by a plurality of pixels 104 and sequentially perform signal processing.

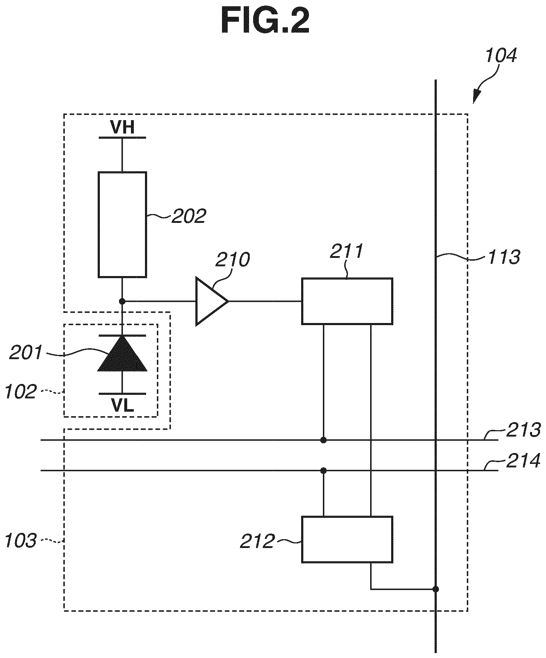

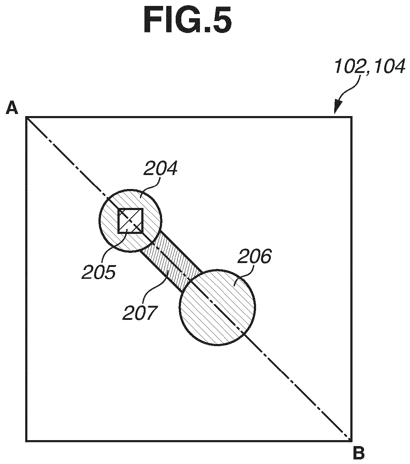

Fig. 2 is a block diagram illustrating an example of the configuration of one of the pixels 104 illustrated in Fig. 1. First, with reference to Fig. 2, Figs. 3A and 3B, and Figs. 4A and 4B, the basic configuration and operation of the pixel 104 including an APD are described. Next, with reference to Fig. 5 and subsequent figures, the detailed configuration of the pixel 104 according to the present exemplary embodiments is described.

As illustrated in Fig. 2, in the photoelectric conversion unit 102 of the pixel 104, an APD 201 is disposed. The APD 201 generates charge pairs according to incident light through photoelectric conversion. To the anode of the APD 201, a potential VL is supplied. To the cathode of the APD 201, a higher potential VH than the potential VL supplied to the anode is supplied. Consequently, reverse bias voltages that cause the APD 201 to perform an avalanche multiplication operation are supplied between the anode and the cathode of the APD 201. The APD 201 is brought into the state where such voltages are supplied, whereby the charges generated by the incident light cause avalanche multiplication, and an avalanche current is generated. In the following description, for simplicity, VL = -Vbd, and VH = Vex. Vbd is the breakdown voltage of the APD 201, and Vex is the excess voltage of the APD 201. Normally, the potential VL is about -20 V to -30 V, and the potential VH is about 2 V to 3 V.

As illustrated in Fig. 2, the signal processing circuit 103 of the pixel 104 can include a quench element 202, a waveform shaping circuit 210, a counter circuit 211, and a selection circuit 212. The aspect of the embodiments, however, is not limited to this. The signal processing circuit 103 may include another circuit regarding signal processing.

The quench element 202 is connected to a supply line that supplies the potential VH and the APD 201. The quench element 202 has the function of converting the avalanche current generated in the APD 201 into a voltage signal. The quench element 202 functions as a load circuit (a quench circuit), and reduce a voltage supplied to the APD 201 when avalanche multiplication occurs, thereby preventing the avalanche multiplication (a quench operation).

The waveform shaping circuit 210 shapes a change in the potential of the cathode of the APD 201 obtained when a photon is detected. Then, the waveform shaping circuit 210 outputs a pulse signal. As a result, the waveform shaping circuit 210 functions as a detection circuit for detecting avalanche breakdown that occurs in the APD 201. As the waveform shaping circuit 210, for example, an inverter circuit may be used. A configuration example where a single inverter is included as the waveform shaping circuit 210 is possible. The aspect of the embodiments, however, is not limited to this. As the waveform shaping circuit 210, a circuit where a plurality of inverters is connected in series may be used. Alternatively, as the waveform shaping circuit 210, another circuit having a waveform shaping effect may be used.

The counter circuit 211 counts the number of pulse signals output from the waveform shaping circuit 210 and holds the counted value. If a reset control pulse is supplied from the vertical scanning circuit 110 illustrated in Fig. 1 to the counter circuit 211 via the driving line 213, the value held in the counter circuit 211 is reset.

To the selection circuit 212, a selection control pulse is supplied from the vertical scanning circuit 110 illustrated in Fig. 1 via the driving line 214, thereby switching electrical connection and disconnection between the counter circuit 211 and the signal line 113. For example, the selection circuit 212 can include a buffer circuit for outputting a signal.

A switch element such as a transistor may be disposed between the quench element 202 and the APD 201 or between the photoelectric conversion unit 102 and the signal processing circuit 103, thereby switching electrical connection. Similarly, the supply of the potential VH or the potential VL to the photoelectric conversion unit 102 may be electrically switched using a switch element such as a transistor.

Fig. 2 illustrates a configuration in which the counter circuit 211 is used. The aspect of the embodiments, however, is not limited to this. The photoelectric conversion apparatus 100 may acquire the timing when a pulse signal output from the waveform shaping circuit 210 is detected, using a time-to-digital converter (TDC) and a memory instead of the counter circuit 211. In this case, the generation timing of the pulse signal output from the waveform shaping circuit 210 is converted into a digital signal by the TDC. To measure the timing when the pulse signal is output, a control pulse pREF is supplied to the TDC from the vertical scanning circuit 110 via driving lines (which can be similar to the driving lines 213 and 214). Using the control pulse pREF as a reference, the TDC acquires as a digital signal a signal in which the input timing of a signal output from the pixel 104 via the waveform shaping circuit 210 is a relative time.

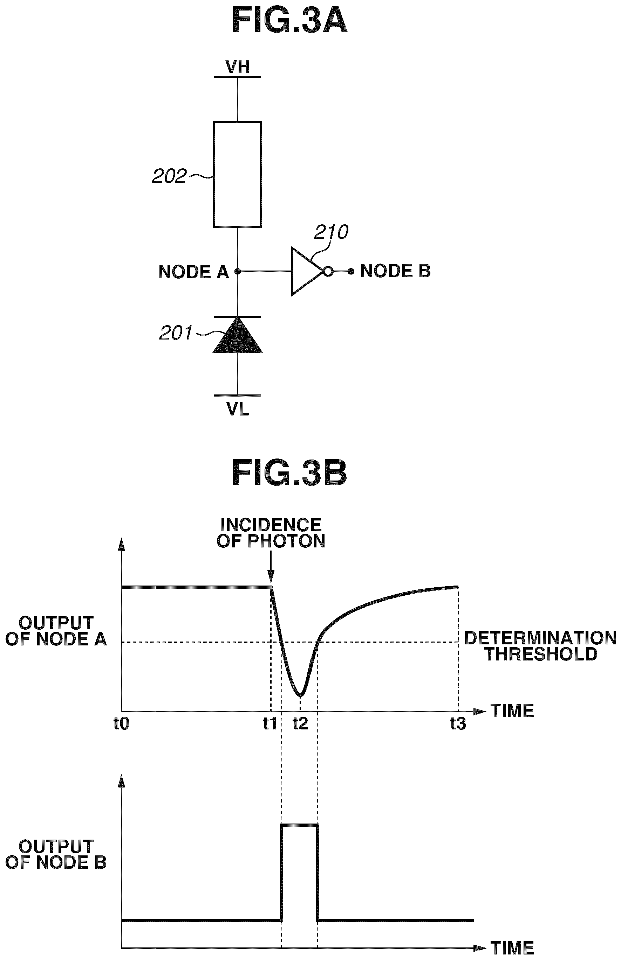

Figs. 3A and 3B are diagrams schematically illustrating the relationships between the operation of the APD 201 and output signals. Fig. 3A is a diagram illustrating excerpts of the APD 201, the quench element 202, and the waveform shaping circuit 210 illustrated in Fig. 2. The input side of the waveform shaping circuit 210 is a node A, and the output side of the waveform shaping circuit 210 is a node B. Fig. 3B illustrates changes in the potentials of the nodes A and B.

From a time t0 and a time t1, the potential difference between the potentials VH and VL (a voltage) is applied to the APD 201. At the time t1, if a photon is incident on the APD 201, avalanche breakdown occurs in the APD 201, an avalanche multiplication current flows through the quench element 202, and the potential of the node A drops. If the amount of the potential drop becomes greater and the potential difference applied to the APD 201 becomes smaller, then as illustrated at a time t2, the avalanche breakdown in the APD 201 stops, and the potential level of the node A does not drop by a certain value or more. The potential at which the avalanche breakdown stops is about 0 V, i.e., the potential at which the voltage applied to the APD 201 is comparable with the breakdown voltage Vbd. Then, between the time t2 and a time t3, a current that compensates for the potential drop flows through the node A from the potential VL. At the time t3, the node A becomes static at the original potential level. At this time, a portion of the output waveform of the node A that exceeds a certain threshold is waveform-shaped by the waveform shaping circuit 210 and output as a signal to the node B.

The quench element 202 and the waveform shaping circuit 210 may be formed on the same semiconductor substrate as the APD 201. The aspect of the embodiments, however, is not limited to this. A chip on which the APD 201 is disposed and a chip on which the quench element 202 and the waveform shaping circuit 210 are disposed may be separately formed and laminated together. For example, as indicated by dotted lines in Fig. 2, a chip (a semiconductor substrate) on which the photoelectric conversion unit 102 is disposed and a chip (a semiconductor substrate) on which the signal processing circuit 103 is disposed may be separately formed and laminated together.

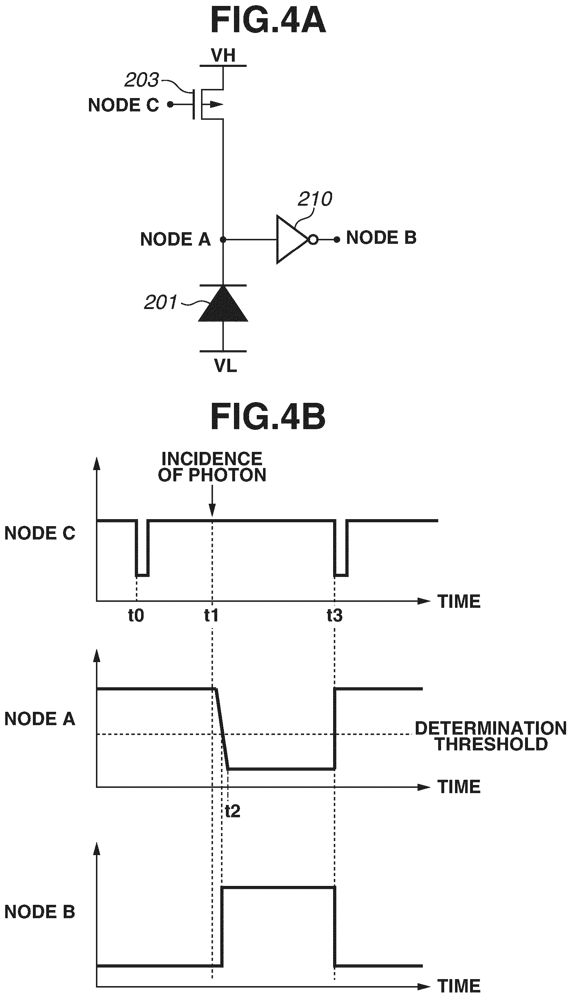

Figs. 4A and 4B are diagrams schematically illustrating the relationships between the operation of the APD 201 having a configuration different from that illustrated in Figs. 3A and 3B and output signals. Although Fig. 4A is an equivalent circuit diagram corresponding to Fig. 3A, a P-channel type (P-type) metal-oxide-semiconductor (MOS) (metal-insulator-semiconductor (MIS)) transistor 203 is disposed instead of the quench element 202. Fig. 4B illustrates changes in the potentials of the nodes A and B and a node C in Fig. 4A. Similarly to Fig. 3A, the nodes A and B are nodes on the input side and the output side, respectively, of the waveform shaping circuit 210. The node C is a node connected to the gate electrode of the transistor 203.

The transistor 203 is a switch for resetting the potential of the node A to the potential VH and is controlled based on the potential of the node C. If the potential of the node C illustrated in Fig. 4B is high, the transistor 203 is an off state (a non-conducting state, hereinafter occasionally referred to as "off"). If the potential of the node C is low, the transistor 203 becomes an on state (a conducting state, hereinafter occasionally referred to as "on"). A cyclic pulse is input to the node C, and Fig. 4B illustrates a part of the cyclic pulse. The operation illustrated in Fig. 4B is described below.

First, at a time t0, the potential of the node A is reset to the potential VH by the transistor 203. Then, if the transistor 203 is turned off, the potential of the node A enters a floating state at the potential VH.

Suppose that at a time t1, a photon is incident on the APD 201. If avalanche breakdown occurs in the APD 201 by the incident photon, the potential of the node A decreases by the avalanche current, and at a time t2, the avalanche breakdown stops. The potential of the node A is in the floating state at the low potential. However, at a time t3, if a pulse that resets the node A is input to the node C, the potential of the node A is reset to the potential VH again. Thus, at the node B on the output side of the waveform shaping circuit 210, an avalanche breakdown detection pulse that is high is generated from the time when the potential of the node A reaches a determination threshold between the times t1 and t2 to the time t3.

In the operation illustrated in Fig. 4B, a case where a next photon is incident between the time t1 when the first photon is incident and the time t3, i.e., a case where a next photon is incident in the state where the potential of the node A remains low, is considered. In this case, the APD 201 cannot cause further avalanche breakdown by the second or subsequent incident photons between the incidence of the first photon and the time t3. Thus, even if a plurality of photons is incident between the times t1 and t3, the number of times avalanche breakdown is detected by the waveform shaping circuit 210 is one. For example, in the operation illustrated in Fig. 4B, if a photon is not incident between the times t0 and t3, the potential of the node A remains at the potential VH, and the potential of the node B remains at a low level. That is, the number of times avalanche breakdown is detected is 0.

In the operation described with reference to Fig. 4B, during the period of one cycle of the reset pulse input to the node C, it is distinguished whether the number of times a photon is incident on the APD 201 is 0 or one or more. Thus, if a plurality of photons is incident during the period of one cycle of the reset pulse input to the node C, signal detection loss occurs. If, on the other hand, photons are uninterruptedly incident one after another, then in the operation described with reference to Fig. 3B, the APD 201 enters a so-called pile-up state where avalanche breakdown does not stop and an avalanche current continues to flow. In the pile-up state, the potential of the node A remains low, and therefore, a detection pulse is not generated by the waveform shaping circuit 210, and the wasteful current flows through the APD 201. Thus, the pile-up is a major issue in the SPAD operation in terms of power consumption.

In addition to the continuous flow of the current due to the pile-up, the following issues can exist in the SPAD operation. The following issues can occur because the multiplication factor in the SPAD operation is large as described above.

One of the issues is the light emission crosstalk. In the APD 201, many carriers are generated by the incidence of a photon. It is known that some of the generated carrier pairs might recombine with emitting light. If avalanche breakdown occurs by an incident photon on a certain pixel 104 in the pixel array 101 including the plurality of pixels 104 (photoelectric conversion units 102), secondary photons emitted from the certain pixel 104 can be incident on pixels 104 near the certain pixel 104 and become false signal. This is termed light emission crosstalk. For example, if it is assumed that as described above, the multiplication factor is one hundred twenty thousand and 0.01% of one hundred twenty thousand carrier pairs generated by a single photon recombine, twelve secondary photons that cause light emission crosstalk are generated.

The next issue is a change of the dark current. Carriers generated by avalanche multiplication are accelerated in a high electric field portion and become so-called hot carriers. Some of the hot carriers are captured in the interface portion near the cathode of the APD 201, and the state of the interface portion changes. In the APD discussed in Japanese Patent Application Laid-Open No. 2018-064086, the portion near the cathode is depleted, and many dark carriers are generated from the interface portion of the cathode. However, the electric field intensity is relatively low near the cathode, and only a small portion of carriers generated at the interface cause avalanche. The carriers generated at the interface that cause this avalanche appear as the dark count of SPAD. If the state of the interface portion changes by capturing the hot carriers, the carrier generation speed at the interface changes, and as a result, the dark count rate (DCR) changes. This change occurs while the SPAD continues to be used. Thus, an issue can arise where the DCR cannot be corrected based on the initial DCR.

Further, as described above, if the number of signal photons is great, consumption energy is great.

For example, if Vbd = 25 V, it is estimated that one hundred twenty thousand carriers are generated by an incident photon and the energy of about 0.5 pJ is consumed. If many pixels are disposed and the number of incident photons is great, consumption energy increases. This can apply a large load to the power supply system of the photoelectric conversion apparatus 100 that performs the SPAD operation.

As described above, since the capacitance component due to a wiring pattern connected to the cathode of the APD 201 or the detection circuit for detecting avalanche breakdown, such as the waveform shaping circuit 210, is large, the multiplication factor of avalanche multiplication is great. Thus, this can cause the issues of light emission crosstalk, a change of the dark current i.e., DCR, and power consumption as described above. If the diode junction capacitance of the cathode of the APD 201 is large, this can be a more serious issue. The diode junction capacitance of the cathode of the APD 201 is a capacitance component different from the capacitance due to the wiring pattern connected to the cathode of the APD 201 or the detection circuit for detecting avalanche breakdown, such as the waveform shaping circuit 210.

In the pile-up state that can occur in the operation illustrated in Fig. 3B, the above issues can conspicuously arise. The operation illustrated in Fig. 4B has a great advantage that such pile-up does not occur. If a plurality of photons is incident during the period of one cycle of the reset pulse input to the node C, signal detection loss can occur. The SPAD, however, is advantageous in detecting a photon in the situation where the number of incident photons is small. In the situation where the number of incident photons is small, a plurality of photons is less likely to be incident during one cycle of the reset pulse. Thus, it is considered that signal detection loss hardly occurs in such a situation. However, the issues of light emission crosstalk, a change in the dark current, and power consumption due to the large multiplication factor can exist also in the operation illustrated in Fig. 4B.

Based on the operation illustrated in Fig. 4B, a detailed description is given below of the photoelectric conversion apparatus 100 according to the present disclosure for reducing light emission crosstalk, a change in the dark current, and power consumption. Each of the exemplary embodiments of the present disclosure, however, is also applicable to the operation illustrated in Fig. 3B.

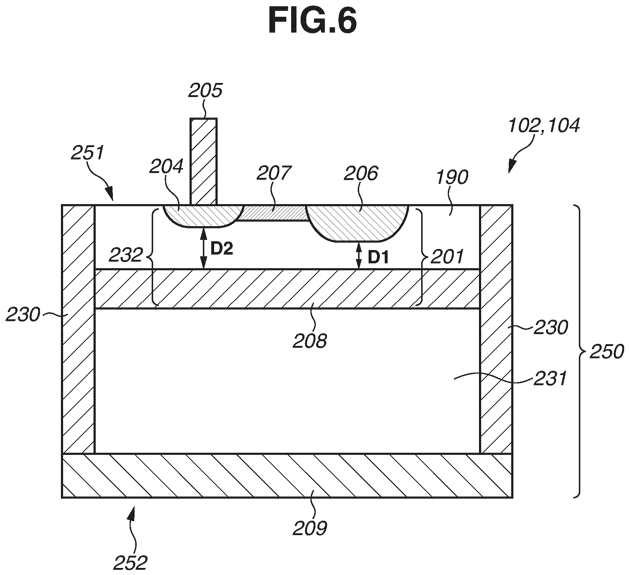

A first exemplary embodiment is described. Fig. 5 is a plan view of the photoelectric conversion unit 102 disposed in the pixel 104 according to the first exemplary embodiment of the present disclosure. Fig. 6 is a cross-sectional view of the photoelectric conversion unit 102 illustrated in Fig. 5 along A-B. Fig. 5 is a plan view of a main surface 251 (a first main surface) of a semiconductor substrate 250 illustrated in Fig. 6.

The photoelectric conversion unit 102 included in the pixel 104 disposed in the photoelectric conversion apparatus 100 is formed in the semiconductor substrate 250 including the main surface 251 and a main surface 252 (a second main surface) on the opposite side of the main surface 251. In the configuration illustrated in Figs. 5 and 6, the photoelectric conversion unit 102 includes a region 204 (a first region), a region 206 (a second region), a region 208 (a third region), and a region 207 (a fourth region).

The region 204 is a region of an N-type conductivity type with a high impurity concentration that constitutes a part of the main surface 251 of the semiconductor substrate 250. The region 204 is connected via a connection pattern 205 to the detection circuit for detecting avalanche breakdown (e.g., the waveform shaping circuit 210). Although the connection pattern 205 does not constitute a part of the main surface 251, Fig. 5 illustrates the connection pattern 205 to facilitate the understanding of the connection position of the region 204 and the connection pattern 205. The region 206 is a region of the N-type conductivity type with a high impurity concentration that is disposed away from the region 204. As illustrated in Fig. 6, the region 206 may constitute a part of the main surface 251 of the semiconductor substrate 250. Unlike the region 204, the region 206 is not directly connected to the connection pattern 205 leading to the detection circuit. As will be described below, the region 206 is connected to the connection pattern 205 via the regions 207 and 204. The region 208 is a region of a P-type conductivity type opposite to the N-type that is disposed at a position closer to the main surface 252 of the semiconductor substrate 250 than the regions 204 and 206.

The region 204 can be the cathode of a photodiode (PD) including a P-N junction composed of the regions 204 and 208. The region 208 can be the anode of the PD composed of the regions 204 and 208. Similarly, the region 206 can be the cathode of an APD including a P-N junction composed of the regions 206 and 208. The region 208 can be the anode of the APD composed of the regions 206 and 208. As illustrated in Fig. 6, the region 208 can be formed over almost the entire surface of the single pixel 104 (the single photoelectric conversion unit 102) between the regions 204 and 206 and the main surface 252 of the semiconductor substrate 250 (below the regions 204 and 206 in Fig. 6). As illustrated in Fig. 6, the region 208 extends from a region 230 on one side to a region 230 on the other side in a cross-sectional view.

The region 207 is disposed between the regions 204 and 206. The regions 204 and 206 are configured to be conductive with each other via the region 207. In one embodiment, the region 207 is a region having a lower impurity concentration than those of the regions 204 and 206. In the configuration illustrated in Figs. 5 and 6, the region 207 is an N-type region having a low impurity concentration that functions as a resistor connecting the regions 204 and 206.

As illustrated in Fig. 6, the photoelectric conversion unit 102 can further include regions 209, 230, 231, and 190. The region 209 is a P-type region formed to constitute the main surface 252 of the semiconductor substrate 250. Each region 230 is a P-type region that is formed at the boundary between pixels 104 (photoelectric conversion units 102) and separates the pixels 104. The region 231 (a fifth region) is a photoelectric conversion region and is a P-type or N-type region having a lower impurity concentration than those of the regions 204 and 206 and disposed between the region 208 and the main surface 252 (the region 209) of the semiconductor substrate 250.

The region 190 is a region disposed between the regions 204, 207, and 206 and the region 208 in a region surrounded by the main surface 251 of the semiconductor substrate 250 and the regions 208 and 230. The region 190 is a P-type or N-type region having a lower impurity concentration than those of the regions 204 and 206. The regions 190 and 231 can be regions having lower impurity concentrations than those of the regions 208, 209, and 230.

In the configuration illustrated in Figs. 5 and 6, when light is incident on the photoelectric conversion unit 102 during the operation of the photoelectric conversion apparatus 100, the P-N junction including the regions 206 and 208 functions as the APD 201 and causes avalanche breakdown. On the other hand, the P-N junction including the regions 204 and 208 does not function as the APD 201 and basically does not cause avalanche breakdown. Thus, hereinafter, the P-N junction including the regions 204 and 208 will occasionally be referred to as a "parasitic PD 232".

To cause the regions 206 and 208 to function as the APD 201 and prevent the regions 204 and 208 from functioning as the APD 201, then as illustrated in Fig. 6, a distance D1 between the regions 206 and 208 is shorter than a distance D2 between the regions 204 and 208. Thus, when the photoelectric conversion apparatus 100 operates, a higher electric field than that of the P-N junction composed of the regions 204 and 208 is generated in the P-N junction composed of the regions 206 and 208. Thus, a depletion region is formed in a region in the region 208 that overlaps the region 206 in orthogonal projection onto the main surface 251 of the semiconductor substrate 250. A charge generated in the region 231 by the incident light passes through the depletion region and flows into the region 206, and avalanche breakdown is caused at this time. When the photoelectric conversion apparatus 100 operates, the region 190 is basically depleted. Thus, the regions 204 and 206 are made electrically conductive with each other mainly via the N-type region 207 that functions as a resistor. The impurity concentration of the first conductivity type of the region 204 may be lower than the impurity concentration of the first conductivity type of the region 206. This can also make avalanche breakdown less likely to occur in the regions 204 and 208.

In the present exemplary embodiment, a photon incident on the region 231 may be incident from the main surface 251 of the semiconductor substrate 250, or may be incident from the main surface 252 of the semiconductor substrate 250. In this case, the photon is incident from the main surface 252 of the semiconductor substrate 250. That is, the photoelectric conversion apparatus 100 is a so-called back surface incidence photoelectric conversion apparatus. The signal processing circuit 103 including the waveform shaping circuit 210 is formed on another substrate connected via the connection pattern 205 to the semiconductor substrate 250 on which the region 231 and the APD 201 are disposed.

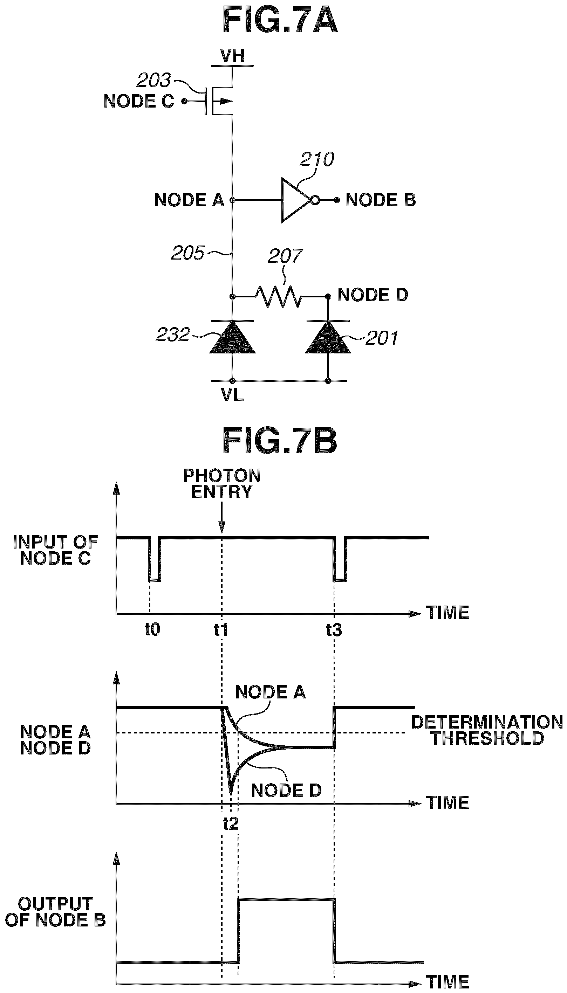

Figs. 7A and 7B are diagrams illustrating an SPAD operation according to the present exemplary embodiment. Fig. 7A illustrates an equivalent circuit diagram of a part of the photoelectric conversion unit 102 and the signal processing circuit 103. Fig. 7B illustrates the potential changes of each of the nodes A to C and a node D in the SPAD operation. The positions of the nodes A to C are similar to those illustrated in Fig. 4A. The node D is the potential of the cathode of the APD 201, i.e., the region 206. If the wiring resistance of the connection pattern 205 is negligible, the node A is the potential of the region 204, which is the cathode of the parasitic PD 232.

First, at a time t0, the potential of the node A is reset to the potential VH and the potential of the node D is reset to the potential VH via the region 207 by the transistor 203. The transistor 203 functions as a reset circuit for resetting the potentials of the regions 204 and 206 to a predetermined potential (the potential VH) according to a reset pulse input to the node C. Then, if the transistor 203 is turned off, the potentials of the nodes A and D enter floating states at the potential VH.

Next, at a time t1, if a photon is incident on the photoelectric conversion unit 102 and avalanche breakdown occurs in the APD 201, the potential of the node D decreases by an avalanche current. At this time, the potential of the node A also decreases by a current flowing through the region 207, but cannot follow the change in the potential of the node D, and the decrease in the potential of the node A is slow. At a time t2, if the avalanche breakdown stops, a current flows via the region 207 so that the potentials of the nodes A and D are same as each other. During this process, the potential of the node A exceeds a threshold for the waveform shaping circuit 210, and a pulse that detects avalanche breakdown in the APD 201 is generated at the node B.

In the above operation, the avalanche current flows from the time t1 to the time t2. The configuration in which the APD 201 is directly connected to the waveform shaping circuit 210 as illustrated in Fig. 4A is referred to as "a configuration of a comparative example". In the changes in the potentials illustrated in Fig. 7B, similarly to the operation illustrated in Fig. 4B in the configuration of the comparative example, the potential of the node D decreases to the potential at which the avalanche breakdown stops. On the other hand, since the region 207 functions as a resistor, the potential of the node A to which a large capacitance component due to the connection pattern 205 or the waveform shaping circuit 210 (the detection circuit) is added cannot follow the potential change of the node D, and the potential change of the node A at the time t2 is small. Thus, if a capacitance component of the parasitic PD 232 added to the configuration of the comparative example is sufficiently small compared to other capacitance components added to the node A, the amount of the charge discharged from the node A is reduced to be small compared to the operation of the configuration of the comparative example. As a result, the multiplication factor of avalanche breakdown that occurs in the APD 201 is reduced compared to the configuration of the comparative example.

A quantitative description is given. As a condition, it is assumed that the size of the pixel 104 is several micrometers square, such as 5 µm square. In this case, the diameter of each of the regions 204 and 206 is about 1 µm, for example. The region 204 constituting the parasitic PD 232 may be smaller than the region 206. Under these conditions, the capacitance of the P-N junction of the region 206 is about 0.8 fF, the additional capacitance (the parasitic capacitance) from the connection pattern 205 to an input portion of the waveform shaping circuit 210 is about 7.2 fF, and the capacitance of the P-N junction of the region 204 is about 0.6 fF. In the present exemplary embodiment, the capacitance due to the disposition of the region 204 increases compared to the configuration of the comparative example. It is, however, understood that the capacitance component due to the region 204 is sufficiently smaller than the capacitance component due to the connection pattern 205 or the waveform shaping circuit 210 from the connection pattern 205 to the input portion of the waveform shaping circuit 210.

Next, to what degree the resistance value of the region 207 that functions as a resistor should be set to achieve the effect of reducing the carrier multiplication factor is considered. The resistance of the region 207 is not necessarily an ohmic resistance. Suppose I1 is a current flowing through the region 207 when the potential difference between the regions 204 and 206 is V1, the resistance of the region 207 is defined as the value of V1/I1, where I1 is 1uA.

First, a decrease in the potential of the cathode (the region 206) of the APD 201 when avalanche breakdown occurs is 2.4 V. An avalanche current in this case is about 50 µA under the above conditions, although depending on the characteristics of the APD 201. Thus, the time until the potential decreases by 2.4 V in the region 206 having a capacitance of 0.8 fF is about 40 ps. At this time, to prevent the potential of the region 204 from following the potential change of the region 206, the product of the resistance value of the region 207 and the capacitance value of the region 206, i.e., a so-called CR time constant, is to be about 40 ps or more. Since the capacitance of the region 206 is 0.8 fF under the above conditions, it is calculated that the resistance value of the region 207 is to be about 50 kΩ or more. Actually, it is possible that the conditions change to some extent. For example, if the avalanche current is 100 µA, the time until the potential of the region 206 decreases by 2.4 V is 20 ps, and the resistance value of the region 207 is to be about 25 kΩ. If the decrease in the potential of the cathode (the region 206) when avalanche breakdown occurs is about 1.9 V, the resistance value of the region 207 is to be about 20 kΩ. Thus, in one embodiment, the region 207 functions as a resistor of 20 kΩ or more. If a configuration that can actually be formed, such as the junction capacitance of the region 206 and the current amount of an avalanche current, is taken into account, it is considered that the effect of reducing the multiplication factor cannot be expected unless the resistance value of the region 207 is at least about 20 kΩ.

On the other hand, the greater the resistance value of the region 207 is, the smaller the multiplication factor is. If, however, the resistance value of the region 207 is too great, the response time from when avalanche breakdown actually starts to when the detection circuit detects the avalanche breakdown is long. For example, if the cycle of the pulse input to the node C is 20 µs, loss in detection of avalanche breakdown occurs unless the detection circuit responds in a time sufficiently shorter than the cycle of the pulse. Thus, if the response time is 0.2 µs or less as a condition, it is estimated that the time constant is 0.2 µs or less, and the upper limit of the resistance value of the region 207 is 250 MΩ. Generally, it is difficult to form a resistor of several hundreds of megaohms in the pixel 104 (the semiconductor substrate 250). Thus, the lower limit of the resistance value of the region 207 is important in the design of the actual pixel 104 (the actual photoelectric conversion unit 102).

As described above, if the multiplication factor when avalanche breakdown occurs is small, the potential change (a decrease in the potential) of the node A is also small. Thus, in one embodiment, the determination threshold is set for avalanche breakdown in the waveform shaping circuit 210 to the value corresponding to the reduced multiplication factor.

The present exemplary embodiment described above with reference to Fig. 5 to Figs. 7A and 7B is summarized. The addition of the capacitance of the P-N junction of the region 204 to the node A due to the disposition of the parasitic PD 232 in the configuration of the comparative example is a disadvantageous element in terms of the reduction of the multiplication factor when avalanche breakdown occurs. The capacitance component of the P-N junction of the region 204, however, is sufficiently smaller than the capacitance component due to the connection pattern 205 or the waveform shaping circuit 210. Thus, the capacitance component of the P-N junction of the region 204 does not influence the multiplication factor. On the other hand, it is possible to reduce electrical conduction between the nodes A and D to a desired degree by setting the resistance value of the region 207 to an appropriate value. Consequently, it is possible to greatly reduce the amount of the charge discharged from the node A when avalanche breakdown occurs, compared to the SPAD operation in the configuration of the comparative example. That is, with the configuration of the present exemplary embodiment, the carrier multiplication factor when avalanche breakdown occurs is reduced, and the present exemplary embodiment exerts the effect of remedying each of the three issues, namely light emission crosstalk, a change in the dark current, and power consumption when many photons are incident.

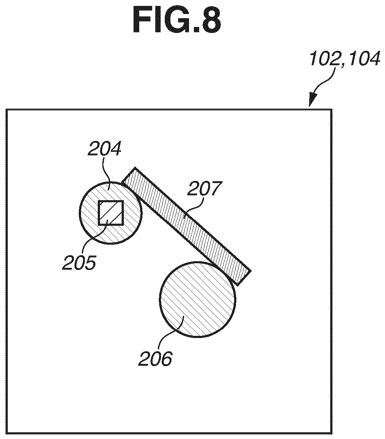

The configuration of each of the parasitic PD 232, the APD 201, and the region 207 is not limited to the configuration illustrated in Figs. 5 and 6. For example, as illustrated in Fig. 8, the region 207 may not connect the regions 204 and 206 by the shortest path, and may connect the regions 204 and 206 by a path around the regions 204 and 206. The region 207 laid out to take a detour lengthens the distance between the regions 204 and 206, and therefore can easily increase the resistance value.

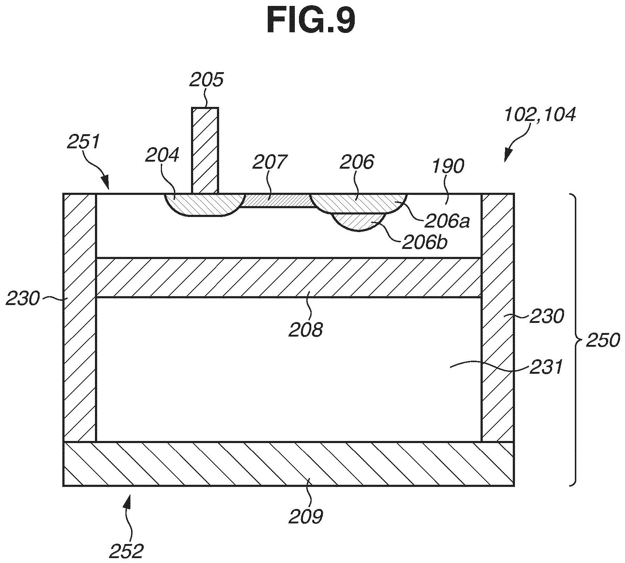

For example, in the configuration illustrated in Fig. 9, the region 206 for constituting the APD 201 has a two-tiered configuration of regions 206a and 206b. The region 206a in the region 206 is a shallow N-type region similar to the region 204 and in contact with the main surface 251 of the semiconductor substrate 250. The region 206b in the region 206 is an N-type region formed in a portion deeper (closer to the main surface 252 of the semiconductor substrate 250) than the region 206a and continuous from the region 206a.

The regions 204 and 206 illustrated in Fig. 6 are regions both having one-layer structures and different in depth from each other, and therefore can be formed by processes using different masks. On the other hand, the region 204 and the region 206a in the region 206 illustrated in Fig. 9 can be formed using the same mask. Thus, the region 204 and the region 206 (the region 206a) are formed such that the planar positional relationship between the region 204 and the region 206 (the region 206a) on the main surface 251 of the semiconductor substrate 250 is a constant positional relationship without depending on the misalignment of the mask. This leads to the stable formation of the resistance value of the region 207, which is an electrical conduction path connecting the regions 204 and 206. The region 206b in the region 206 is formed using a mask different from the mask used to form the regions 204 and 206a.

Also in this case, the position of a depletion region in the P-type region 208 is merely determined, and the misalignment of the mask in the region 206b relative to the region 206a does not greatly influence the characteristics.

The configurations illustrated in Figs. 8 and 9 may be used in combination. The configurations illustrated in Figs. 8 and 9 are applied, whereby it is possible to achieve an SPAD operation in which the multiplication factor is reduced and the characteristics are stabilized. That is, this can contribute to a further improvement in the characteristics of the photoelectric conversion apparatus 100.

In the configurations illustrated in Figs. 6 and 9, the region 206 is disposed up to a region closer to the main surface 252 of the semiconductor substrate 250 than the region 204, thereby making the distance between the regions 206 and 208 shorter than the distance between the regions 204 and 208. The aspect of the embodiments, however, is not limited to this. For example, the regions 204 and 206 may have the same shape, and a portion of the region 208 that overlaps the region 206 may have a step to come close to the region 206. For example, the regions 204 and 206 may be formed using the same mask. On the other hand, the region 208 may include a uniform region as illustrated in Figs. 6 and 9, and a region continuous from the uniform region to come close to the region 206 from the uniform region in a region overlapping the region 206 in orthogonal projection onto the main surface 251 of the semiconductor substrate 250. This can also achieve an SPAD operation in which the combined multiplication factor of the APD 201 and the parasitic PD 232 is reduced as described above. Since the regions 204 and 206 can be formed using a single mask, similarly to the configuration illustrated in Fig. 9, the characteristics of the SPAD operation can be stabilized.

The outer edge of each of the regions 204, 206, and 208 may be a portion having a concentration one-tenth of that of a portion having the highest impurity concentration in the region. For example, the outer edge of each of the regions 204, 206, and 208 may be a portion having a concentration one-hundredth of that of the portion having the highest impurity concentration in the region. Further, for example, the outer edge of each of the regions 204, 206, and 208 may be a portion that is continuous from the portion having the highest impurity concentration in the region and has an impurity concentration of 1 × 10¹⁶. If each region and a region adjacent to the region are of conductivity types different from each other, the outer edge of each of the regions may be a portion where the conductivity type changes.

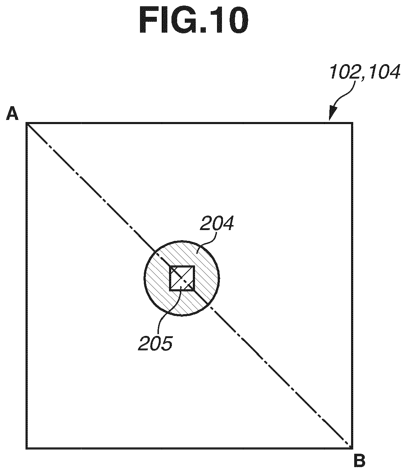

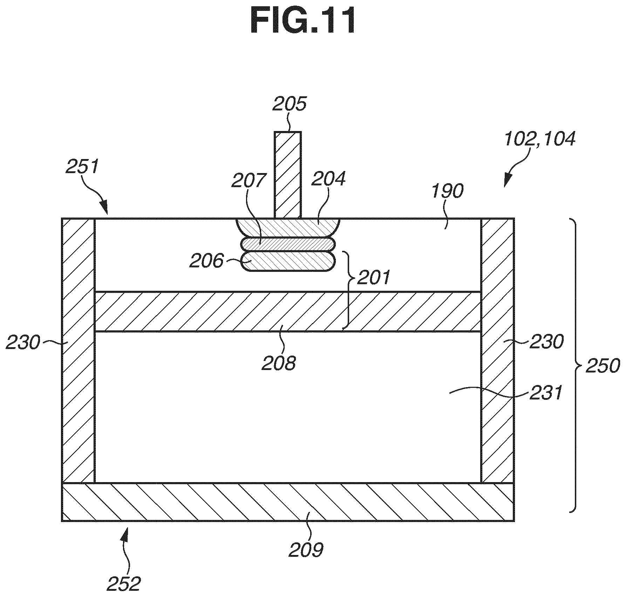

Next, the photoelectric conversion apparatus 100 according to a second exemplary embodiment of the present disclosure is described. Fig. 10 is a plan view of the photoelectric conversion unit 102 disposed in the pixel 104 according to the present exemplary embodiment. Fig. 11 is a cross-sectional view of the photoelectric conversion unit 102 illustrated in Fig. 10 along A-B. Fig. 10 is a plan view of the main surface 251 of the semiconductor substrate 250 illustrated in Fig. 11. An equivalent circuit according to the present exemplary embodiment illustrated in Figs. 10 and 11 can be similar to the circuit according to the first exemplary embodiment illustrated in Fig. 7A and described with reference to Figs. 5 to 9, and an operation according to the present exemplary embodiment can also be similar to that according to the first exemplary embodiment.

In the present exemplary embodiment, as illustrated in Fig. 11, the regions 204 and 206 have a structure where the regions 204 and 206 are formed together in the depth direction. More specifically, the region 206 is disposed between the regions 204 and 208. The depth direction is a direction from the main surface 251 to the main surface 252 of the semiconductor substrate 250. Hereinafter, there is a case where as a position approaches the main surface 252 from the main surface 251, the position is represented as "becoming deeper".

The APD 201 is composed of the regions 206 and 208. In the region 207, low-concentration P-type impurities or low-concentration N-type impurities are doped. In the region 207, a low-density electron layer of the N-type conductivity type is formed when the photoelectric conversion apparatus 100 operates, regardless of the conductivity type of the impurities. Then, the region 207 serves as a resistor connecting the regions 204 and 206. In a case where the region 207 is an effective N-type region, the operation of the region 207 is similar to that in the first exemplary embodiment. An "effective" conductivity type means the conductivity type with the higher impurity concentration in a case where P-type impurities and N-type impurities coexist, and the difference between the concentrations of the impurities is an effective concentration. In the above and following exemplary embodiments, the conductivity type of each region can be an effective conductivity type.

A description is given below of a case where the region 207 is an effective P-type region, while the majority carriers of the region 207 are electrons. If the region 207 that is an effective P-type impurity region is a neutral region or is in a completely depleted state when the photoelectric conversion apparatus 100 operates, electrical conduction between the regions 204 and 206 is disconnected, and the region 206 of the APD 201 is always in a floating state. Thus, information regarding the occurrence of avalanche breakdown in the APD 201 is not transmitted to the region 204, and the APD 201 does not function as an SPAD.

If, on the other hand, the thickness in the depth direction and the impurity concentration of the P-type region 207 are appropriate, the majority carriers of the region 207 can be low-density electrons, and the region 207 can function as a resistor between the regions 204 and 206. Specifically, the Debye length of the P-type region 207 is set to be comparable with the thickness in the depth direction of the region 207. Consequently, the majority carriers of the region 207 can be low-density electrons.

The regions 204 and 206 are high-concentration N-type regions and have high-density electrons as the majority carriers. The quasi Fermi levels of the regions 204 and 206 do not change so that the majority carriers of the P-type region 207 are holes. This is because restrictions on changes in the quasi Fermi levels are determined based on the Debye length. Thus, in the P-type region 207, electrons are the majority carriers although the density of the electrons is low, and the region 207 can act as a resistor. In a case where the region 207 is a P-type region having an appropriate concentration, it is easier to achieve an electron layer having a lower density than in a case where the region 207 is an N-type region. Thus, the region 207 easily functions as a region having a higher resistance. The distance between the regions 204 and 206 in the configuration illustrated in Fig. 11 can be shorter than those in the configurations described with reference to Figs. 5 to 9. Thus, it can be more necessary to heighten the resistance per unit length of the region 207 than in the above configurations.

As described above, in a case where the region 207 acts as a resistor and indicates a desired resistance value, then based on an operating principle similar to that of the first exemplary embodiment described with reference to Figs. 5 to 9, it is possible to reduce the multiplication factor when avalanche breakdown occurs more than in the SPAD in the comparative example. As a result, also with the configuration illustrated in Figs. 10 and 11, it is possible to remedy the issues of light emission crosstalk, a change in the dark current, and power consumption due to the large multiplication factor.

Further, as illustrated in Figs. 10 and 11, the regions 204 and 206 are disposed to overlap each other in orthogonal projection onto the main surface 251 of the semiconductor substrate 250. Thus, the areas of the regions 204 and 206 are smaller than those in the plan view in Fig. 5. Thus, in a case where the size of the pixel 104 (the photoelectric conversion unit 102) is reduced, it can be easy to apply this configuration. Further, three layers, namely the regions 204, 206, and 207, can be formed using the same mask. Consequently, variation in the characteristics due to the misalignment of the mask between the regions 204, 206, and 207 is less likely to occur. Further, it is possible to reduce manufacturing costs.

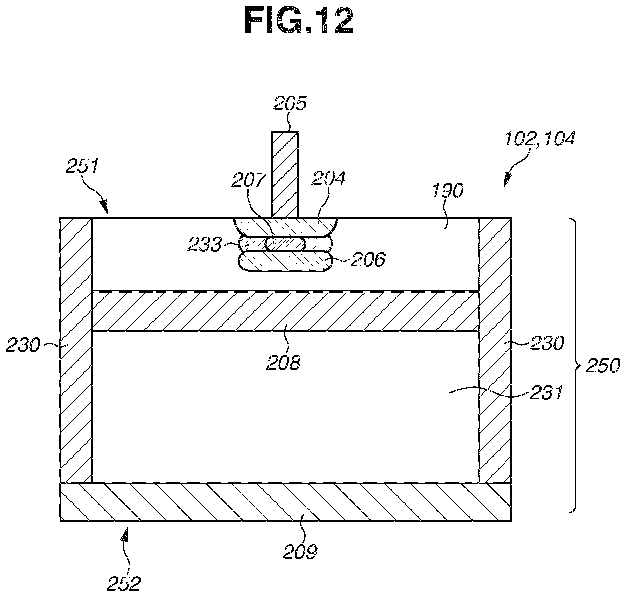

Fig. 12 is a variation of the configuration illustrated in Fig. 11. In the configuration illustrated in Fig. 12, a region 233 (a sixth region) is a P-type region, and effective P-type impurities are doped into the P-type region at a concentration that basically depletes the P-type region when the photoelectric conversion apparatus 100 operates. The region 207 is an N-type or P-type impurity doping region having almost the same depth as that of the region 233 and locally formed in center portions of the regions 204 and 206 in orthogonal projection onto the main surface 251 of the semiconductor substrate 250. As described above, the region 207 is a region where low-density electrons are the majority carriers when the photoelectric conversion apparatus 100 operates. Thus, in a case where the region 207 is of the P-type, the effective impurity concentration of the region 207 is lower than the effective impurity concentration of the region 233.

In the configurations illustrated in Figs. 11 and 12, the region 207 is an electrical conduction path between the regions 204 and 206. In the configuration illustrated in Fig. 12, the region 207 has a smaller cross-sectional area orthogonal to the direction in which a current flows than in the configuration illustrated in Fig. 11, and therefore is likely to obtain a greater resistance value. The regions 204, 206, and 233 can be formed using the same mask. In the configuration illustrated in Fig. 12, N-type impurities may be further doped into in the region 207 using a mask different from the mask used to form the regions 204, 206, and 233 in the region 233. Consequently, the region 207 can be an effective N-type region or a P-type region having a lower effective impurity concentration than that of the region 233. A mask used to form the connection pattern 205 may be used to form the region 207. The N-type impurities for forming the region 206 have a distribution of which a center portion substantially expands in the depth direction. Thus, depending on the design of the distribution of the impurity concentration of each region, the region 207 might be locally formed at the same time as when the regions 204, 206, and 233 are formed using the same mask.

In the configuration of the present exemplary embodiment, the regions 204 and 206 are disposed to overlap each other in orthogonal projection onto the main surface 251 of the semiconductor substrate 250. In this case, the region 206 may be disposed within the region 204. Alternatively, the region 204 may be disposed within the region 206.

Also with the configuration of the present exemplary embodiment, similarly to the configuration illustrated in the first exemplary embodiment, it is possible to reduce the carrier multiplication factor when avalanche breakdown occurs. Consequently, the present exemplary embodiment exerts the effect of remedying each of the above issues of light emission crosstalk, a change in the dark current, and power consumption. Further, also in a case where the size of the pixel 104 is small, it is possible to effectively apply the configuration of the present exemplary embodiment in which the regions 204, 207, and 206 overlap each other. Further, with the configuration in which the regions 204, 207, and 206 overlap each other, it is possible to prevent an increase in manufacturing processes and further reduce variation in the characteristics.

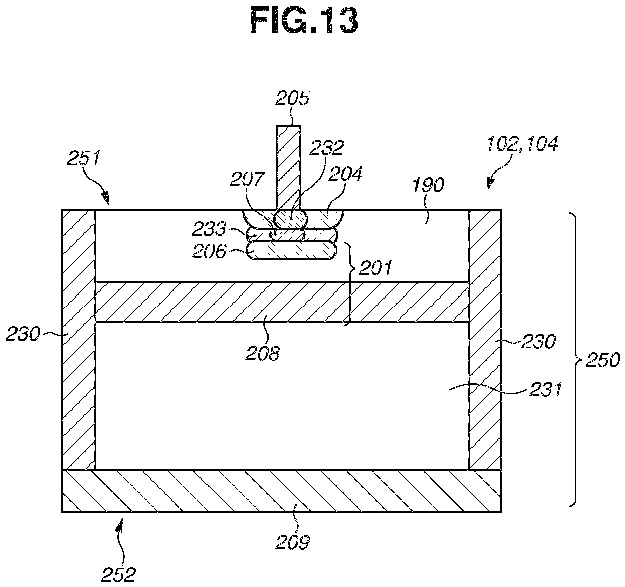

Next, with reference to Fig. 13, the photoelectric conversion apparatus 100 according to a third exemplary embodiment of the present disclosure is described. Fig. 13 is a cross-sectional view of the photoelectric conversion unit 102 disposed in the pixel 104 according to the present exemplary embodiment. The photoelectric conversion apparatus 100 according to the present exemplary embodiment is different from that according to the variation of the second exemplary embodiment illustrated in Fig. 12 in that the photoelectric conversion unit 102 includes a region 232. The present exemplary embodiment is substantially similar to the second exemplary embodiment except for this difference and points described below, and therefore, the description of the similar portions is occasionally omitted. A circuit diagram and an SPAD operation according to the present exemplary embodiment are also similar to those in the operation described with reference to Fig. 5 and Figs. 7A and 7B.

The region 232 according to the present exemplary embodiment is connected via the connection pattern 205 to the detection circuit for detecting avalanche breakdown. The region 232 is a region of the N-type conductivity type with a high impurity concentration that constitutes a part of the main surface 251 of the semiconductor substrate 250. The region 232 makes an ohmic connection between the region 204 and the connection pattern 205. The N-type impurity concentration of the region 232 is higher than the N-type impurity concentration of the region 204. In a planar view, the region 204 is disposed around the region 232.

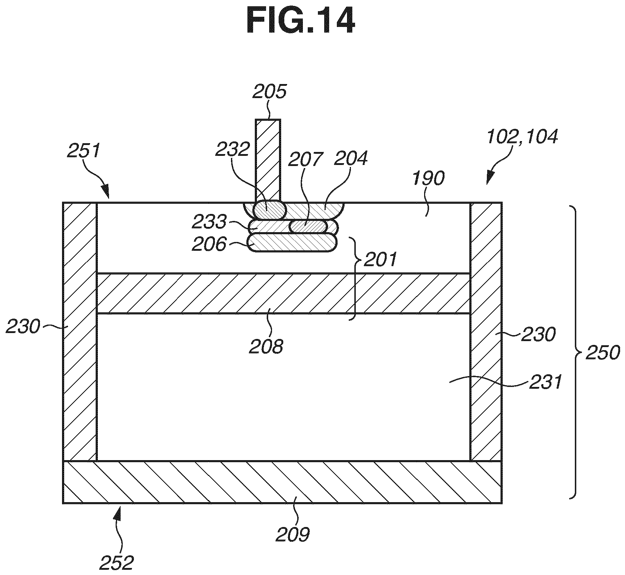

In the planar view, the region 207 is disposed at a position overlapping the connection pattern 205. In this case, after the process of forming a through-hole in which the connection pattern 205 is provided, the region 207 can be formed using the through-hole. N-type impurities may be doped into a depth comparable with that of the region 233. On the other hand, in this case, the resistance value of the region 207 may be influenced by the region 232. To make the resistance value less likely to be influenced, then as illustrated in Fig. 14, the region 207 and the connection pattern 205 may be placed without overlapping each other in the planar view.

A suitable impurity concentration of each region is described below. The "impurity concentration" refers to an effective impurity concentration and refers to an impurity concentration that is the difference between the impurity concentrations of P-type and N-type impurities that coexist. The following impurity concentrations are merely examples, and the regions described in the exemplary embodiments are not limited to the ranges of the following impurity concentrations.

For example, in one embodiment, the impurity concentration of the region 204 is in the range of 1 × 10¹⁵ to 1 × 10²⁰ cW⁻³and the impurity concentration of the region 206 is in the range of 5 × 10¹⁶ to 2 × 10¹⁸ cm⁻¹. The impurity concentration of the region 206 is set to a predetermined value or more, whereby it is easy to cause the region 206 to function as a part of the APD 201. The impurity concentration of the region 206 is set to a predetermined value or less, whereby it is easy to electrically separate the region 206 from the region 204. In another embodiment, the impurity concentration of the region 208 is in the range of 2 × 10¹⁶ to 2 × 10¹⁷ cm⁻³. The impurity concentration of the region 208 is set to a predetermined value or more, whereby it is easy to cause the region 208 to function as a part of the APD 201. The impurity concentration of the region 208 is set to a predetermined value or less, whereby it is easy to deplete a part of the region 208 up and down through the region 208 when the photoelectric conversion apparatus 100 operates. The impurity concentration of the region 233 is determined based on the distance between the regions 204 and 206 and the impurity distributions in the regions 204 and 206. Thus, in one embodiment, the impurity concentration of the region 233 is in the range of 2 × 10¹⁶ to 2 × 10¹⁸ cm⁻³, for example, although the range differs depending on the conditions, and the impurity concentration of each of the regions 209 and 230 is in the range of 5 × 10¹⁶ to 2 × 10¹⁸ cW⁻³, for example. In another embodiment, the impurity concentration of the region 232 is in the range of 1 × 10¹⁹ to 1 × 10²¹ cm⁻³, for example. It does not matter whether the region 207 is of the P-type or the N-type as described above. For example, the region 207 forms a conduction path as a P-type or N-type region having an impurity concentration of 5 × 10¹⁶ cm⁻³ or less, for example, by doping N-type impurities into a part of the region 233. The region 233 is depleted when the photoelectric conversion apparatus 100 operates, but the potential of the portion of the region 207 in the depleted region 233 becomes low for electrons, and this portion becomes a conduction path for electrons. If the semiconductor substrate 250 before ions are implanted is of the P-type, there can also be a case where a part of the semiconductor substrate 250 located between the regions 204 and 206 is the P-type region 233 without doping P-type impurity ions for forming the region 233.

Although in Fig. 13, the impurity concentrations of the regions 204 and 232 are varied, the region 204 may be formed at a high impurity concentration comparable with that of the region 232, and impurities may not be doped into a region equivalent to the region 232. When the region 232 is formed, the region 207 may be naturally formed by pulling the tail of the N-type impurity distribution in the depth direction.

Also with the configuration of the present exemplary embodiment, similarly to the configurations illustrated in the first and second exemplary embodiments, it is possible to reduce the carrier multiplication factor when avalanche breakdown occurs.

Consequently, the present exemplary embodiment exerts the effect of remedying each of the above issues of light emission crosstalk, a change in the dark current, and power consumption. Due to the presence of the region 232, further, also in a case where the size of the pixel 104 is small, it is possible to effectively apply the configuration of the present exemplary embodiment in which the regions 204, 207, and 206 overlap each other. Further, with the configuration in which the regions 204, 207, and 206 overlap each other, it is possible to prevent an increase in manufacturing processes and further reduce variation in the characteristics.

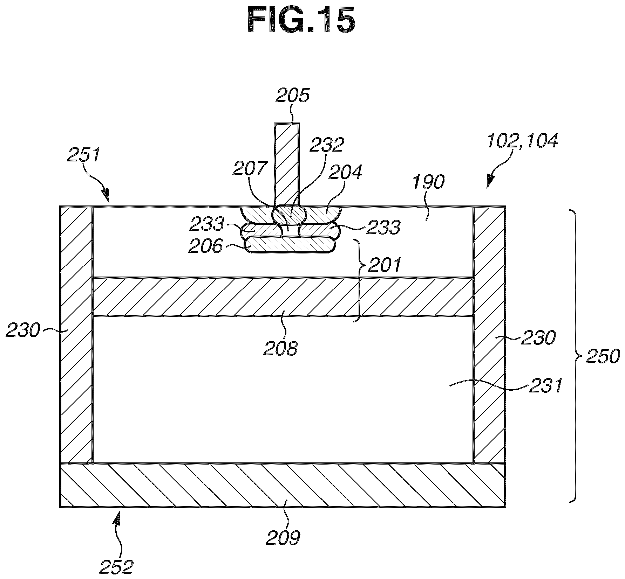

Next, with reference to Fig. 15, the photoelectric conversion apparatus 100 according to a fourth exemplary embodiment of the present disclosure is described. Fig. 15 is a cross-sectional view of the photoelectric conversion unit 102 disposed in the pixel 104 according to the present exemplary embodiment. The photoelectric conversion apparatus 100 according to the present exemplary embodiment is different from that according to the third exemplary embodiment illustrated in Fig. 13 in that the region 233 has a doughnut shape in which a center portion of the region 233 is hollow in a planar view. The present exemplary embodiment is substantially similar to the third exemplary embodiment except for this difference and points described below, and therefore, the description of the similar portions is occasionally omitted. A circuit diagram and an SPAD operation according to the present exemplary embodiment are also similar to those in the operation described with reference to Fig. 5 and Figs. 7A and 7B.

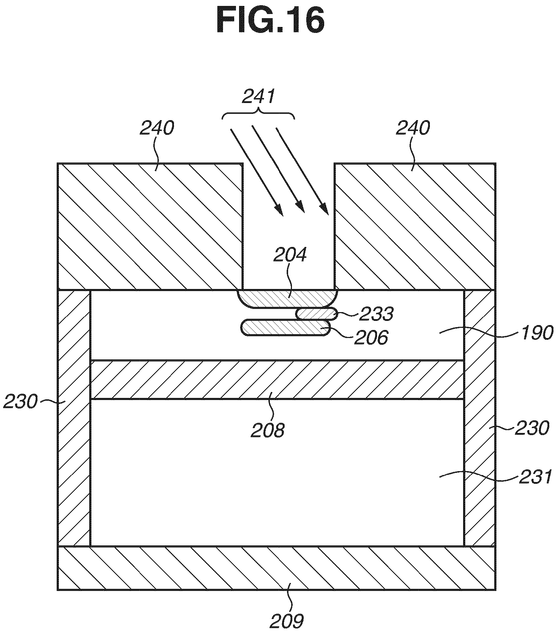

Fig. 16 is a diagram illustrating a method for forming the region 233 of the photoelectric conversion unit 102 disposed in the pixel 104 according to the present exemplary embodiment. In Fig. 16, a resist 240 is disposed on the semiconductor substrate 250. The resist 240 is used to form the regions 204, 206, and 233. P-type impurity ions 241 are ions used to form the region 233.

According to a normal semiconductor manufacturing process, after the resist 240 is applied to the entire surface of the semiconductor substrate 250, the resist 240 in a region overlapping the regions 204 and 206 in the planar view is partially removed by etching.

Next, the region 204 equivalent to a first cathode is formed by shallowly implanting N-type impurity ions. The region 206 equivalent to a second cathode is formed by implanting N-type impurity ions at a predetermined depth. As illustrated in Fig. 16, the doughnut-shaped region 233 is formed by obliquely implanting the P-type impurity ions 241 into an interface of the semiconductor substrate 250 while rotating the semiconductor substrate 250. The hollow portion is a P-type semiconductor or an N-type semiconductor having a low impurity concentration. It is possible to form a desired region 207 by controlling the impurity concentration of the region 190, the impurity concentration of the region 233, and the diameter of the hollow portion.

To form the P-type or N-type region 207 having a low impurity concentration by doping N-type impurities into the region 233, the number of N-type impurities to be doped per unit area is to be almost comparable with the number of P-type impurities in the region 233. For example, if the P-type impurity concentration of the region 233 is 1 × 10¹⁷/cm³ and the impurity concentration of N-type impurities to be doped to form the region 207 is 1.1 × 10¹⁷/cm³, the N-type region 207 having a concentration of 1 × 10¹⁶/cm³ is formed. Into the N-type region 207 having a concentration of 1 × 10¹⁶/cm³, P-type and N-type impurity ions having a combined concentration of 2.1 × 10¹⁷/cm³ are doped. If the region 207 is a cube having a side length of 0.3 µm, N-type impurity ions having a concentration of 1.1 × 10¹⁷ × (0.3 × 10⁻⁴) to the power of three, i.e., 2970 N-type impurity ions, exist in the region 207. Similarly, 2700 P-type impurity ions exist in the region 207. Then, the effective number of N-type impurity ions is (2970 - 2700), i.e., 270. These numbers are average numbers, and the actual numbers vary. Statistics show that the standard deviation of variation is the root of the average number. In this case, variation in the total number of P-type and N-type impurity ions is the root of (2970 + 2700), i.e., about 75. That is, the standard deviation of the variation is 75 with respect to an average of 270 as the effective number of N-type impurity ions. Thus, even in the case of an N-type carrier conduction path having a concentration of 1 × 10¹⁶/cm³, if the N-type carrier conduction path is represented by variation comparable with that of the standard deviation, the concentration is 1 ±0.28 × 10¹⁶/cm³, and very great variation occurs. The cause of this great variation is the coexistence of many P-type impurity ions and many N-type impurity ions in the region 207 as described above. If great variation occurs in the region 207 among many pixels 104, i.e., the resistance value of the region 207 greatly differs with respect to each pixel 104, the effect of the aspect of the embodiments decreases in an actual operation. According to the present exemplary embodiment, however, only a small number of impurities exist in the hollow portion in the center of the region 233 to be the region 207. If the numerical values in the above example are applied, an average of 270 N-type impurity ions merely exist in the region 207. The standard deviation of variation in the 270 N-type impurity ions is the root of 270, i.e., about 16, and is greatly reduced compared to the standard deviation of the variation in the above example, i.e., 75. Thus, according to the present exemplary embodiment, variation in the characteristics among many pixels is small, and similarly to the first to third exemplary embodiments, the present exemplary embodiment exerts the effect of remedying each of the three issues, namely light emission crosstalk, a change in the dark current, and power consumption when many photons are incident.

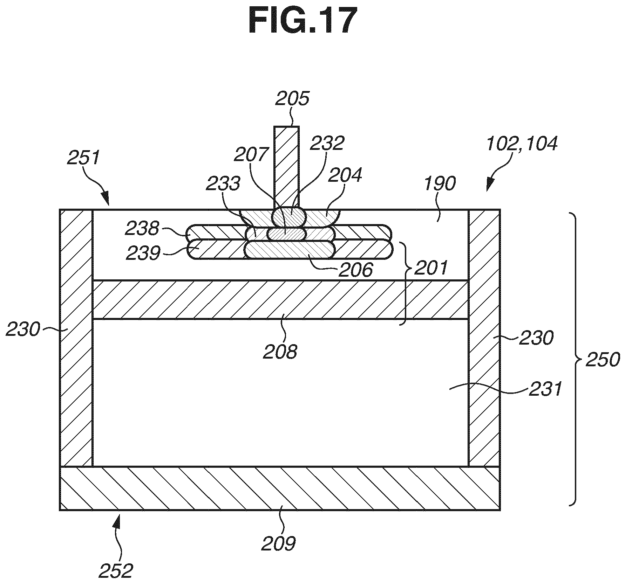

Next, with reference to Fig. 17, the photoelectric conversion apparatus 100 according to a fifth exemplary embodiment of the present disclosure is described. Fig. 17 is a cross-sectional view of the photoelectric conversion unit 102 disposed in the pixel 104 according to the present exemplary embodiment. The photoelectric conversion apparatus 100 according to the present exemplary embodiment is different from that according to the third exemplary embodiment illustrated in Fig. 13 in that the photoelectric conversion unit 102 includes regions 238 and 239. The present exemplary embodiment is substantially similar to the third exemplary embodiment except for this difference and points described below, and therefore, the description of the similar portions is occasionally omitted. A circuit diagram and an SPAD operation according to the present exemplary embodiment are also similar to those in the operation described with reference to Fig. 5 and Figs. 7A and 7B.

The region 238 is a P-type region formed in a wider range than that of the region 233 to surround the region 233 in a planar view at a depth comparable with that of the region 233 in a cross-sectional view. The region 239 is an N-type region formed in a wider range than that of the region 206 to surround the region 206 in the planar view at a depth comparable with that of the region 206 in the cross-sectional view. The regions 233 and 206 have shapes overlapping the region 204 in the planar view. The regions 238 and 239 have shapes overlapping each other in the planar view. Although the following description is given on the premise of a case where the regions have the above shapes, the regions are not limited to these shapes.

The region 207 can be formed by doping N-type impurities into a part of the region 233. In this case, however, as described in the fourth exemplary embodiment, if the impurity concentration of the region 233 is high, the characteristics of the region 207 can greatly vary. To reduce the great variation in the characteristics, in one embodiment, the concentration of the P-type impurities of the region 233 is lower. However, it may be difficult to lower the concentration of the P-type impurities of the region 233 without causing variation.

Fig. 16 illustrates the state where the P-type impurity ions 241 for forming the doughnut-shaped region 233 are obliquely implanted into the semiconductor substrate 250 after the regions 204 and 206 are formed in an opening portion of the resist 240. It is, however, not easy to form a doughnut shape with high accuracy. Thus, basically, a uniform region 233 is formed by implanting the P-type impurity ions 241 almost perpendicularly into the semiconductor substrate 250. When the regions 204 and 206 are formed, an N-type impurity layer having a significant concentration is deposited between the regions 204 and 206, i.e., in a region where the region 233 should be formed. Thus, to form the region 233 to exceed the concentration of the N-type impurities and electrically separate the regions 204 and 206, a situation can occur where a greater number of P-type impurities is to be doped. The cause of such an issue occurs when the region 206 is formed. Generally, if impurity ions are implanted, a certain distribution occurs in the depth direction of a semiconductor substrate. Thus, also when the region 206 is formed, a certain N-type impurity distribution occurs on the shallower side of the peak of the region 206. This issue, however, arises by another mechanism.

Generally, in the formation of a semiconductor element, the process of forming a desired opening portion in a resist and then implanting impurity ions into a semiconductor substrate is repeated. Basically, in one embodiment, only impurity ions that enter the opening portion of the resist are selectively doped into the semiconductor substrate. If, however, the area of the opening is small and energy for implanting impurity ions is high to form the element in a deep portion, a phenomenon where some of impurity ions implanted into the resist enter the opening portion is remarkable. That is, the ions implanted into the resist and having relatively high energy proceed in the depth direction inside the resist while gradually losing kinetic energy. These impurity ions randomly move in the planar direction, and therefore, particularly impurity ions implanted at a position close to the opening of the resist may come out to the opening portion of the resist and enter the semiconductor substrate in the opening portion. Such impurity ions lose some kinetic energy by the time when the impurity ions come out to the opening portion of the resist, and the impurity ions as a whole are deposited on the shallower side of a desired depth. Many such unnecessary impurity ions are generated near the boundary of the opening portion of the resist. If the area of the opening of the resist is great, such unnecessary impurity ions influence the vicinity of the boundary of the opening of the resist. If, however, the area of the opening is small, practically, such unnecessary impurity ions enter the entire region of the opening of the resist.

When N-type impurity ions are implanted to form the region 206, the above situation occurs, and unnecessary N-type impurity ions passing through a resist are deposited on the shallower side of the depth at which the region 206 is formed, i.e., in the region where the region 233 should be formed. Thus, more P-type impurity ions are used to form the region 233. In a portion where the region 207 is formed, many P-type and N-type impurity ions coexist, and this may cause great unevenness in the characteristics of the region 207 as described in the fourth exemplary embodiment. A method for facilitating a reduction in such great variation in the characteristics of the region 207 is described below.

In the present exemplary embodiment, the impurity concentration of the region 206 is decreased, thereby decreasing the amount of implantation itself of N-type ions when the region 206 is formed. Unnecessary N-type impurity ions that enter the region where the region 233 should be formed also decrease in proportion to the amount of implantation. On the other hand, the region 206 equivalent to the second cathode takes a role in forming the APD 201 with the region 208, and therefore uses the minimum impurity concentration. Thus, the region 239, which has a planarly wider region than that of the region 206, is caused to take a part of the role in forming the region 206. The region 239 is formed by implanting N-type impurity ions under almost the same energy conditions as those for the implantation of N-type impurity ions for forming the region 206. Consequently, it is possible to reduce the amount of N-type impurity ions used to form the region 206.

For example, suppose that the amount per unit area of N-type impurity ions used for the region 206 is 1 × 10¹³/cm². Then, the amount of implantation of N-type impurity ions for forming the region 206 is 6 × 10¹²/cm², and the amount of implantation of N-type impurities for forming the region 239 is 4 × 10¹²/cm². In one embodiment, N-type impurity ions to be doped into the region of the region 206 by combining both the amounts of implantation are 1 × 10¹³/cm², which is the used amount. In one embodiment, when the region 239 is formed, unnecessary N-type impurity ions passing through a resist only influence the vicinity of the boundary of the region of the region 239 and hardly enter the region of the region 233. Thus, the region 206 is formed together with the region 239, whereby it is possible to reduce the amount of unnecessary N-type impurity ions that enter the region of the region 233. Consequently, it is possible to reduce the amount of P-type impurity ions to be doped to form the region 233, i.e., the amount of N-type impurity ions to be doped to form the region 207. Thus, it is possible to reduce unevenness in the characteristics of the region 207. When the photoelectric conversion apparatus 100 operates, in one embodiments, in the region 239, a region other than the region 206 is depleted. This is because, if not, the capacitance of the P-N junction of the region 206 increases, and the purpose of reducing the carrier multiplication factor when avalanche occurs, which is the original purpose of the aspect of the embodiments, is at least partially undermined.

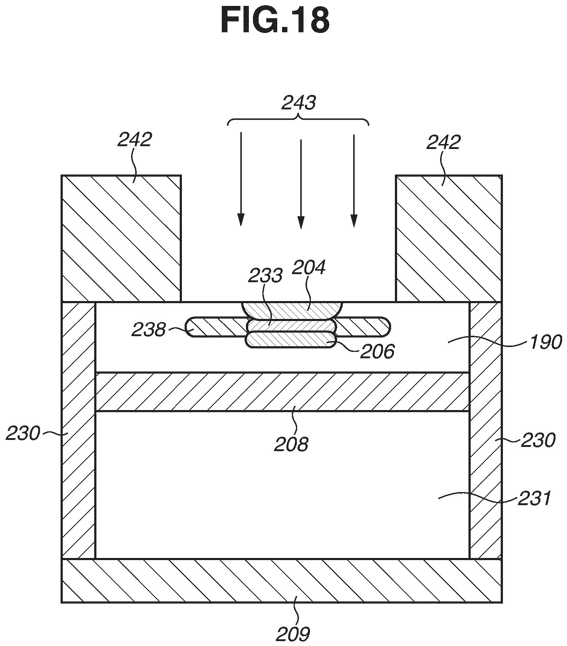

Fig. 18 is a pixel cross-sectional view of the process of forming the regions 238 and 239 illustrated in Fig. 17. After ions are implanted into the regions 204, 206, and 233, the process illustrated in Fig. 18 is performed without performing a thermal process. In Fig. 18, a resist 242 having as an opening a region where the region 238 is formed is disposed on the semiconductor substrate 250. Arrows indicate the direction of the implantation of P-type impurity ions 243 for forming the region 238. After the region 238 is formed, next, N-type impurity ions for forming the region 239 are implanted using the same resist 242.

It is known that generally, if impurity ions are implanted parallel to the crystal axis of a semiconductor substrate, the ions are channeled and deeply enter the semiconductor substrate beyond a desired depth in the semiconductor substrate. Normally, a direction perpendicular to the surface of the semiconductor substrate is also the direction of the crystal axis, and therefore, if impurity ions are implanted in a direction perpendicular to the surface of the semiconductor substrate, channeling occurs. On the other hand, the crystal structure of a semiconductor region into which impurity ions are doped at a high concentration partially collapses, and the semiconductor region is partially amorphized. Thus, even if impurity ions are implanted into the amorphized region, channeling is prevented because the crystal axis is collapsed.

In the process in Fig. 18, ions are already implanted into the regions 204, 206, and 233. Particularly, impurity ions having a high concentration of about 1 × 10¹⁸ cW⁻³ or more are doped into the region 204, and this portion is amorphized. If P-type impurity ions for forming the region 238 are implanted in this state, channeling is prevented in the portion of the region 204 in the planar view, and channeling occurs in other portions. P-type impurity ions deeply enter the portions where the channeling occurs, and some of the P-type impurity ions also reach the region 239. Thus, the effective N-type impurity concentration of the region 239 decreases, and the region 239 is likely to be depleted in this portion. On the other hand, in the portions of the regions 204 and 206 in the planar view, the proportion of P-type impurity ions that reach the depth of the region 206 is smaller, and the effective N-type impurity concentration of the region 206 does not decrease much. Thus, the method for forming the region 238 illustrated in Fig. 18 selectively decreases the N-type impurity concentration of a region in the region 239 other than the portions of the regions 204 and 206 in the planar view, thereby enabling this portion to be the depleted when the photoelectric conversion apparatus 100 operates.

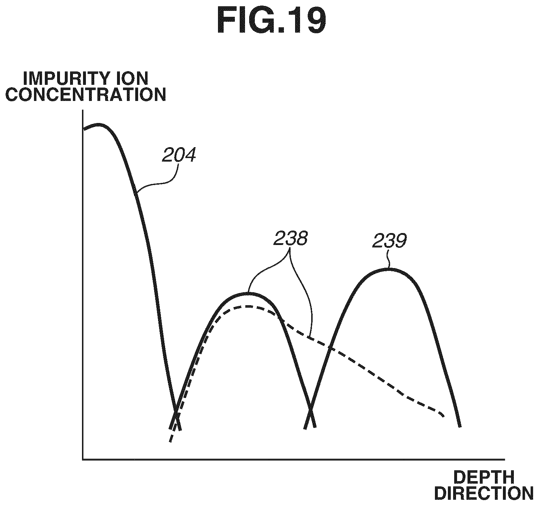

Fig. 19 illustrates the depth direction distributions of impurity ions in the regions 204, 238, and 239. Between the two distributions of impurity ions in the region 238, a solid line indicates the distribution in the portions of the regions 204 and 206 on a planar layout. A dotted line indicates the distribution in other portions, and it is indicated that the distribution greatly extends to the region 239.

The P-type impurity concentration of the region 233 is determined based on the sum of both the implantation of P-type impurities in the process illustrated in Fig. 16 and the implantation of P-type impurities in the process illustrated in Fig. 18. However, there can also be a case where P-type impurities are not implanted in the process illustrated in Fig. 16. To prevent channeling, the implantation of N-type impurity ions into the region 206 or 239 may be oblique direction implantation slightly shifted from the direction of an axis perpendicular to the surface of the semiconductor substrate 250. In this manner, the characteristics of the APD 201 formed by the regions 206 and 208 are excellent, and the impurity distribution in a region in the region 239 other than the region 206 greatly overlaps that in the region 238. Thus, this region is likely to be depleted in an actual operation.

After the process of forming the region 238 and forming the region 239 that is illustrated in Fig. 18 ends, the region 207 is formed. The region 207 may be formed in the same process as the region 232, or may be formed in a different process from the region 232. In the case of the different process, the regions 207 and 232 may be disposed at positions that do not overlap each other in the planar view as illustrated in Fig. 14. There can also be a case where the N-type impurity concentration of the region 204 is set to a very high concentration and the region 232 is not formed. The region 232 may be slightly deeply formed, thereby also simultaneously forming the region 207.

Also with the configuration of the present exemplary embodiment, similarly to the configurations illustrated in the first to fifth exemplary embodiments, it is possible to reduce the carrier multiplication factor when avalanche breakdown occurs. According to the present exemplary embodiment, after variation in the characteristics is reduced, the present exemplary embodiment exerts the effect of remedying each of the three issues, namely light emission crosstalk, a change in the dark current, and power consumption when many photons are incident.

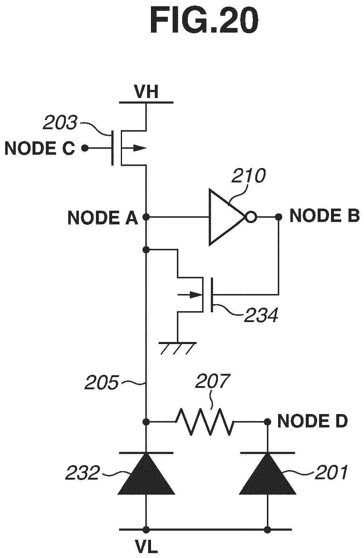

Next, with reference to Fig. 20, an SPAD operation according to a sixth exemplary embodiment of the present disclosure is described. Fig. 20 is an equivalent circuit diagram of a part of the photoelectric conversion unit 102 and the signal processing circuit 103. In the configuration illustrated in Fig. 20, a transistor 234 is added compared to the equivalent circuit illustrated in Fig. 7A. The transistor 234 is an N-type MOS transistor. The gate electrode of the transistor 234 is connected to the node B. If the node B becomes high, the transistor 234 is turned on and sets the potentials of the nodes A and D to the potential level at which the APD 201 does not cause avalanche breakdown. In other words, the transistor 234 functions as a setting circuit that, in a case where the waveform shaping circuit 210 (the detection circuit) detects avalanche breakdown, sets the potentials of the regions 204 and 206 to the potential at which avalanche breakdown does not occur in the photoelectric conversion unit 102. In the configuration illustrated in Fig. 20, if the transistor 234 is turned on, the potentials of the regions 204 and 206 becomes 0 V, which is the ground level.

In the first to fifth exemplary embodiments, as illustrated in Fig. 7B, as a result of reducing the multiplication factor when avalanche breakdown occurs, the potentials of the nodes A and D maintain high potentials even after avalanche breakdown occurs. Thus, if a photon is further incident in this state, further avalanche breakdown may occur, and the potentials of the nodes A and D can become lower potentials due to discharge by an avalanche current. In this case, the node B is already at the high level by the incidence of the first photon, and the state of the node B does not change by the incidence of the second or subsequent photon. That is, avalanche breakdown caused by the incidence of the second or subsequent photon is not detected as a signal, and an unnecessary electron-hole pair is generated.

Accordingly, the transistor 234 is disposed in the circuit illustrated in Fig. 20. If avalanche breakdown occurs by the incidence of a single photon during one cycle of the cyclic reset pulse input to the node C, the signal of the node B emitted from the waveform shaping circuit 210 becomes the high level, which indicates that avalanche breakdown is detected. Consequently, the transistor 234 is turned on, and the nodes A and D become the ground level. As a result, even if a subsequent photon is incident until the next reset pulse is input to the node C, avalanche breakdown does not occur in the APD 201. That is, the occurrence of avalanche breakdown is reduced to the minimum necessary.

The present exemplary embodiment is effective in a case where the transistor 203 operates as the reset circuit for resetting the potentials of the region 204 (the node A) and the region 206 (the node D) to the predetermined potential. When the nodes A and D are reset by the transistor 234 (the transistor 234 is turned on), an electron-hole pair is not generated in the APD 201. The reset by the transistor 234 is discharge by a potential difference of about 2 V to the ground level. Thus, required electrical energy is far smaller than that for discharge by a potential difference of about 20 to 30 V to the great negative potential VL when avalanche breakdown occurs.

According to the present exemplary embodiment, in addition to a reduction in the carrier multiplication factor when avalanche breakdown occurs, it is possible to prevent the occurrence of unnecessary avalanche breakdown in one cycle of the reset pulse cyclically input to the node C. Thus, the present exemplary embodiment has the effect of remedying the issues of light emission crosstalk, a change in the dark current, and power consumption more than the first to fifth exemplary embodiments.

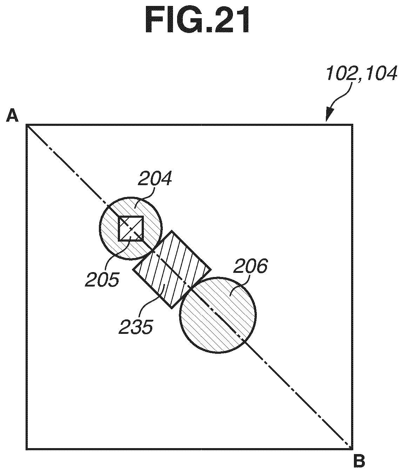

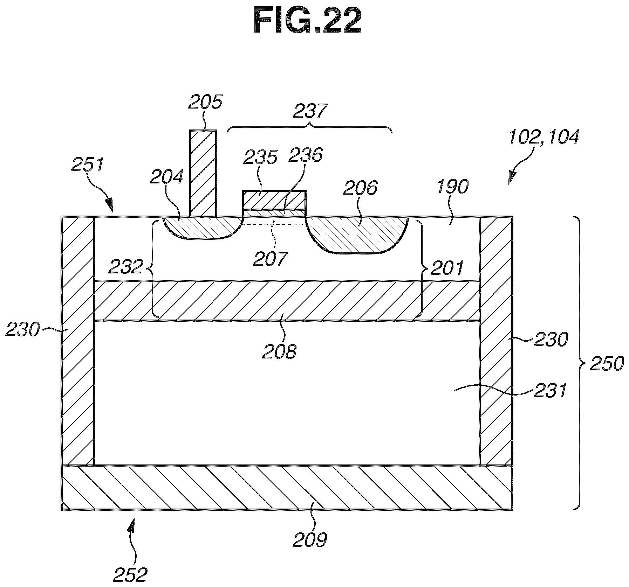

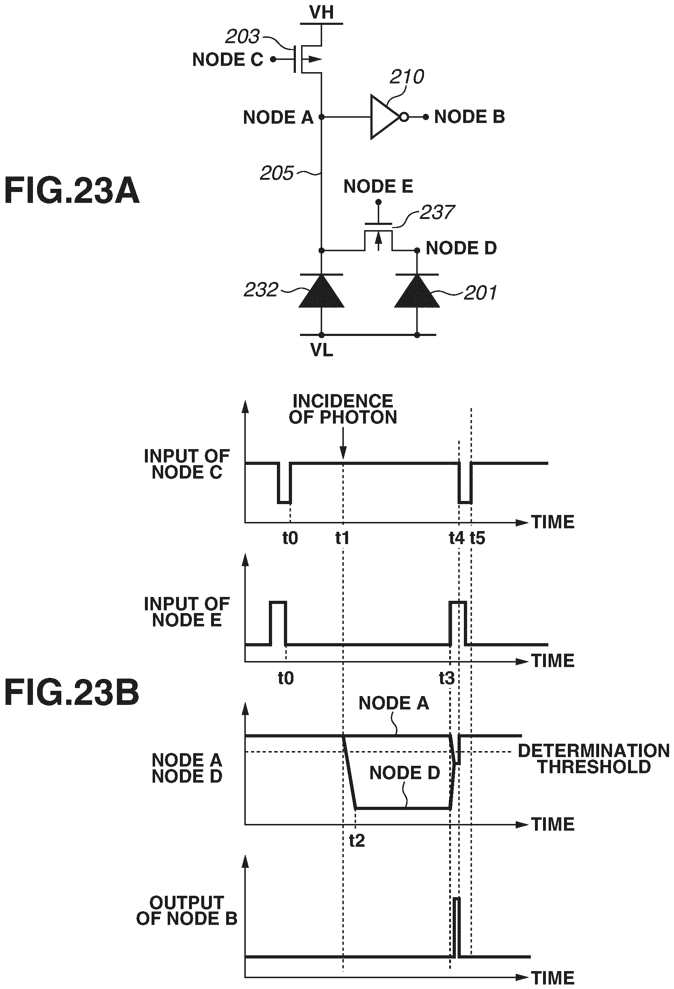

Next, with reference to Fig. 21 to Figs. 23A and 23B, the photoelectric conversion apparatus 100 according to a seventh exemplary embodiment of the present disclosure is described. Fig. 21 is a plan view of the photoelectric conversion unit 102 disposed in the pixel 104 according to the present exemplary embodiment. Fig. 22 is a cross-sectional view of the photoelectric conversion unit 102 illustrated in Fig. 21 along A-B. Fig. 21 is a plan view of the main surface 251 of the semiconductor substrate 250 illustrated in Fig. 22. Fig. 23A illustrates an equivalent circuit diagram of a part of the photoelectric conversion unit 102 and the signal processing circuit 103. Fig. 23B illustrates a change in the potential of each of the nodes A to D and a node E in an SPAD operation. The positions of the nodes A to D are similar to those illustrated in Fig. 7A. The node E is a node connected to a gate electrode 235 of a transistor 237.

In the configuration illustrated in Figs. 21 and 22, the region 206 can constitute a part of the main surface 251 of the semiconductor substrate 250. Further, the photoelectric conversion unit 102 includes the transistor 237 that causes each of the regions 204 and 206 to function as a source region or a drain region and causes the region 207 to function as a channel region. The transistor 237 is an N-type MOS transistor. The transistor 237 includes the gate electrode 235 and a gate insulating film 236 disposed between the gate electrode 235 and the main surface 251 of the semiconductor substrate 250. Since the region 190 is basically depleted when the photoelectric conversion apparatus 100 operates, whether to form the channel region (the region 207) immediately below the gate electrode 235 is determined by controlling the potential of the gate electrode 235. As a result, conduction between the regions 204 and 206 is controlled by the transistor 237. As illustrated in the equivalent circuit diagram in Fig. 23A, the transistor 237 is disposed between the node D connected to the cathode of the APD 201 and the node A connected to the cathode of the parasitic PD 232.

Next, with reference to Fig. 23B, the SPAD operation according to the present exemplary embodiment is described. To the node E connected to the gate electrode 235 of the transistor 237, a pulse that cyclically turns on the transistor 237 is input. Consequently, the transistor 237 becomes conductive in a predetermined cycle. To the node C, a reset pulse is input in the same cycle as that of the node E. Consequently, the transistor 203 that functions as the reset circuit for resetting the potentials of the regions 204 and 206 to the predetermined potential (the potential VH) resets the potentials of the regions 204 and 206 in the same cycle as that of the transistor 237.

At a time t0, the reset of the nodes A and D ends. While the transistor 237 is conductive by the input of the pulse to the node E, the reset pulse is input to the node C, and the transistor 203 is turned on. Consequently, the reset is started, and not only the potential of the region 204 (the node A) but also the potential of the region 206 (the node D) is reset. Next, the transistor 237 is turned off, and then, the transistor 203 is turned off. Consequently, the nodes A and D enter floating states at the potential VH.

At a time t1, if a photon is incident, avalanche breakdown occurs in the APD 201. Then, the potential of the region 206 (the node D) decreases to near the ground level, and avalanche multiplication stops. At this time, the discharge capacitance of the node D having a small capacitance is small, and therefore, the carrier multiplication factor is small. At a time t2, the node D remains in the floating state at the potential at which the avalanche multiplication stops.

Next, at a time t3, the node E becomes high, and the transistor 237 is turned on. Consequently, the nodes A and D become conductive, and the potentials of the nodes A and D change to be the same potential. The potential of the node A decreases, and the potential of the node D increases, but a capacitance added to the node A is great, and a capacitance added to the node D is small. Thus, the change in the potential of the node A is small. The waveform shaping circuit 210 (the detection circuit) detects avalanche breakdown according to the potential of the node A (the region 204) when the transistor 237 becomes conductive.

Thus, a determination threshold for the waveform shaping circuit 210 is set to an appropriate value so that the waveform shaping circuit 210 can detect a small change in the potential of the node A, whereby avalanche breakdown is detected in the APD 201.

At a time t4, if the potential of the node C becomes low and the transistor 203 is turned on, the nodes A and D are reset again. Next, at a time t5, if the potential of the node C becomes high, the nodes A and D return to the states at the time t0 again.

In the present exemplary embodiment, the carrier multiplication factor when avalanche breakdown occurs may be reduced to be smaller than in the first to fifth exemplary embodiments. In the configurations illustrated in the first to fifth exemplary embodiments, the nodes A and D are always somewhat electrically conductive with each other via the region 207 that functions as a resistor. Thus, when avalanche breakdown occurs in the APD 201, some discharge occurs at the node A having a great capacitance. On the other hand, in the present exemplary embodiment, electrical conduction between the nodes A and D can be almost completely disconnected while the transistor 237 is turned off and the channel region is not generated. Thus, when avalanche breakdown occurs in the APD 201, discharge at the node D having a small load capacitance occurs.

A case is considered where a plurality of photons is incident during one cycle of the reset performed by the transistor 203 (the reset circuit). Even in this case, in the present exemplary embodiment, the potential of the node D sufficiently decreases to about the ground level due to avalanche breakdown that occurs by the first incident photon. Thus, avalanche breakdown does not occur by the incidence of the second or subsequent photon. Thus, in the present exemplary embodiment, it is not necessary to dispose the transistor 234 as illustrated in the third exemplary embodiment.

According to the present exemplary embodiment, it is possible to reduce the carrier multiplication factor when avalanche breakdown occurs further than in the above exemplary embodiments. Thus, the present exemplary embodiment exerts the effect of further remedying each of the above three issues, namely light emission crosstalk, a change in the dark current, and power consumption.

Next, the photoelectric conversion apparatus 100 according to an eighth exemplary embodiment of the present disclosure is described. The present exemplary embodiment can also be said to be a variation of the seventh exemplary embodiment. Similarly to the configuration illustrated in Figs. 21 and 22, the APD 201 and the parasitic PD 232 are connected together by the transistor 237.

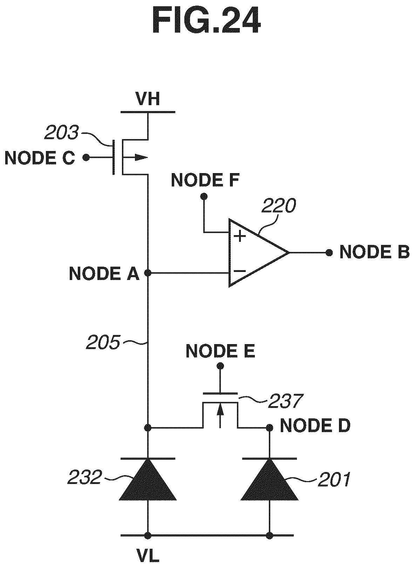

On the other hand, in the present exemplary embodiment, as illustrated in Fig. 24, as the detection circuit for detecting avalanche breakdown, a comparator 220 is used instead of the waveform shaping circuit 210. To a "-" input terminal of the comparator 220, the node A is connected. To a "+" input terminal of the comparator 220, a node F is connected.

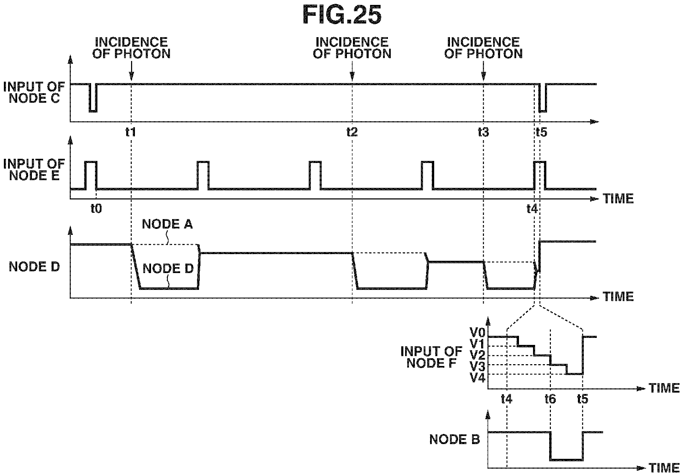

Next, with reference to Fig. 25, an SPAD operation according to the present exemplary embodiment is described. In the present exemplary embodiment, in a single signal detection operation (an operation between two successive reset pulses input to the node C), the photoelectric conversion apparatus 100 operates to count the number of incident photons and performs signal processing in response to the incidence of a plurality of photons.

As illustrated in Fig. 25, also in the present exemplary embodiment, similarly to the seventh exemplary embodiment, a pulse is cyclically input to the node E, and the transistor 237 becomes conductive in a predetermined cycle. On the other hand, to the node C, unlike the seventh exemplary embodiment, a reset pulse is not input in the same cycle as that of the node E, and a reset pulse that resets the potentials of the regions 204 and 206 is input every time the transistor 237 becomes conductive a predetermined number of times. In the example illustrated in Fig. 25, if the pulse is input to the node E four times, a single reset pulse is input to the node C. The relationship between the reset pulse input to the node C and the pulse input to the node E when the reset pulse is input to the node C can be similar to the relationship illustrated in Fig. 23B.

During one cycle in which the reset pulse is input to the node C, the pulse that makes the transistor 237 conductive multiple times is cyclically input to the node E. In the example illustrated in Fig. 25, at times t1, t2, and t3, photons are incident. This is the incidence in the first, third, and fourth cycles among four cycles in which the pulse is input to the node E during one cycle in which the reset pulse is input to the node C. Even if photons are incident and avalanche breakdown occurs in the APD 201, the transistor 237 becomes conductive by the input of the pulse to the node E, and the potential of the node D (the region 206) increases. Thus, avalanche breakdown occurs three times in the APD 201 in response to the respective three incident photons. Every time the transistor 237 is turned on, the potential of the node A decreases. As a result, the potential of the node A decreases by an amount corresponding to the total amount of discharge in the avalanche breakdown that occurs three times. The potential of the node A from the time t4 to the time t5 is the potential dropped by the amount corresponding to the total amount of discharge in the avalanche breakdown that occurs three times. A capacitance added to the APD 201 (the region 206) is small, and the amount of discharge in avalanche breakdown that occurs once is small. Thus, the present exemplary embodiment uses the fact that even in a case where the node A (and the node D) is not reset to the potential VH, avalanche breakdown can occur multiple times in the APD 201.

Fig. 25 illustrates the nodes F and B from the time t4 to the time t5 in an enlarged manner. To the node F connected to the "+" input terminal of the comparator 220, step-like potentials V0, V1, V2, V3, and V4 are input. Vn (n = 0, 1, 2, 3, 4) is a potential corresponding to the number of times avalanche breakdown occurs during one cycle of the reset pulse input to the node C. Each value is set so that if Vn where n ≥ k in response to avalanche breakdown that occurs k times is input to the node F, the node B corresponding to the output of the comparator 220 is inverted from high to low.

Generally, a current always flows through the comparator 220 while the comparator 220 is operating, and therefore, the comparator 220 may operate during the period from the time t4 to the time t5. During a current-off period other than the period from the time t4 to the time t5, the potential of the node B can also be set to high. Since the circuit configuration of such a comparator is very general, the details are not described.

In the example illustrated in Fig. 25, at a time t6 when the node F becomes V3, the node B is inverted. Thus, it is determined that the number of times avalanche breakdown occurs is three times. As described above, before the transistor 237 becomes conductive the predetermined number of times and the transistor 203 (the reset circuit) resets the potentials of the nodes A and D, the comparator 220 (the detection circuit) generates a multivalued signal according to the potential of the node A. Consequently, in a single signal detection operation (an operation between two successive reset pulses input to the node C), it is possible to count the number of times avalanche breakdown occurs multiple times by the incidence of a plurality of photons.

The present exemplary embodiment is not limited to the configuration illustrated in Fig. 24. There can also be a circuit configuration in which a stationary current is not applied when the comparator 220 operates. There can also be a case where the connection between the parasitic PD 232 and the APD 201 is the region 207 that functions as a resistor as in the first and second exemplary embodiments. In a case where the region 207 functions as a resistor, a configuration is possible in which an N-type transistor of which a source region is connected to the node A and a drain region is connected to the "-" input terminal of the comparator 220 is disposed between the "-" input terminal of the comparator 220 and the node A, and the gate electrode of the N-type transistor is set to a constant potential. Using a saturation region operation of this transistor, discharge is performed from the drain region by avalanche breakdown that occurs in the APD 201. As long as the saturation region operation is maintained, a change in the potential corresponding to the total amount of discharged charges by an avalanche current corresponding to avalanche breakdown that occurs multiple times occurs in the drain region. The comparator 220 can detect the change in the potential of the drain region and count the number of times avalanche breakdown occurs.

The number counted by the comparator 220 and the number of times avalanche breakdown actually occurs do not necessarily match each other. A circuit that converts an analog amount, namely the total amount of discharged charges generated by avalanche breakdown that occurs multiple times, into a digital amount is to be included. For example, a digital signal "1" may correspond to avalanche breakdown that occurs "2.5" times in the APD 201. That is, conversion gain obtained by dividing the digital signal by the number of times avalanche breakdown that actually occurs can also take a value other than 1. If the conversion gain is set to be small, it is possible to represent a great number of times of avalanche breakdown using a small digital signal.

Further, for example, instead of the comparator 220, a circuit equivalent to a source follower may be connected to the node A. In this case, the circuit connected to the node A may have a configuration used in a reading circuit of a so-called complementary metal-oxide-semiconductor (CMOS) sensor that performs analog-to-digital (AD) conversion on the output of the source follower.

As described with reference to Fig. 2, generally, in an SPAD, addition is performed on the number of times avalanche breakdown occurs, using the counter circuit 211 in each pixel 104. The maximum count number is determined based on the number of bits of the counter circuit 211. Since the size of the pixel 104 is limited, the number of bits of a counter that can be formed is also limited. Thus, if the conversion gain obtained by dividing the digital signal by the number of times of avalanche breakdown that actually occurs is reduced, it is possible to deal with the incidence of a greater number of photons. That is, it is possible to increase saturation signals of the pixel 104. Particularly, in a case where the number of incident photons is great, such a reduction in the conversion gain can be effective.

According to the present exemplary embodiment, similarly to the seventh exemplary embodiment, it is possible to reduce the carrier multiplication factor when avalanche breakdown occurs. That is, the present exemplary embodiment exerts the effect of remedying the above three issues, namely light emission crosstalk, a change in the dark current, and power consumption. It is also possible to lower the cycle of the reset pulse input to the node C compared to the seventh exemplary embodiment. Thus, it is possible to reduce power consumption required for a driving pulse (a reset pulse).

Further, as described above, it is also possible to increase saturation signals of a pixel.

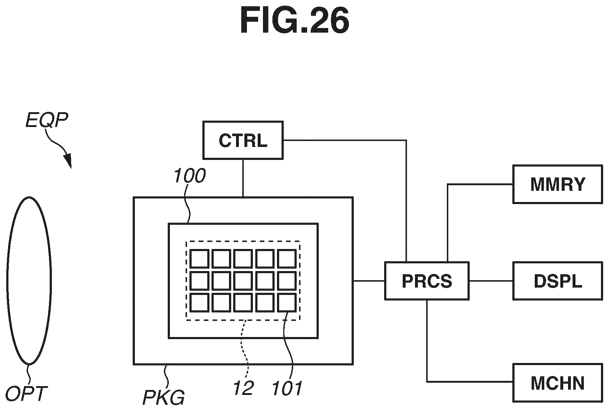

An application example of the photoelectric conversion apparatus 100 according to each of the above exemplary embodiments is described below. Fig. 26 is a schematic diagram of an equipment EQP on which the photoelectric conversion apparatus 100 is mounted. As illustrated in Fig. 26, the photoelectric conversion apparatus 100 is accommodated in a semiconductor package PKG. The package PKG can include a base to which the photoelectric conversion apparatus 100 is fixed, a cover such as glass opposed to the photoelectric conversion apparatus 100, and a conductive connection member, such as a bonding wire or a bump, connecting a terminal provided in the base and a terminal provided in the photoelectric conversion apparatus 100. The equipment EQP may further include at least any of a control apparatus CTRL, a processing apparatus PRCS, a display apparatus DSPL, and a storage apparatus MMRY.

An optical system OPT forms an image on the pixel array 101, and for example, can be a lens, a shutter, or a mirror. The control apparatus CTRL controls the operation of the photoelectric conversion apparatus 100, and can be a semiconductor device such as an application-specific integrated circuit (ASIC). The processing apparatus PRCS processes a signal output from the photoelectric conversion apparatus 100, and can be a semiconductor apparatus such as a central processing unit (CPU) or an ASIC. The display apparatus DSPL can be an electroluminescent (EL) display apparatus or a liquid crystal display apparatus that displays data obtained by the photoelectric conversion apparatus 100. The storage apparatus MMRY can be a magnetic device or a semiconductor device that stores data obtained by the photoelectric conversion apparatus 100. The storage apparatus MMRY can be a volatile memory such as a static random-access memory (SRAM) or a dynamic random-access memory (DRAM), or a non-volatile memory such as a flash memory or a hard disk drive. The machine apparatus MCHN can include a movable unit or a propulsive unit such as a motor or an engine. For example, the machine apparatus MCHN drives a component of the optical system OPT for zooming, focusing, or a shutter operation. The equipment EQP displays data output from the photoelectric conversion apparatus 100 on the display apparatus DSPL, or transmits data output from the photoelectric conversion apparatus 100 to outside, using a communication apparatus (not illustrated) included in the equipment EQP. To this end, the equipment EQP may include the storage apparatus MMRY or the processing apparatus PRCS.

The equipment EQP into which the photoelectric conversion apparatus 100 is incorporated can also be applied to a monitoring camera or an in-vehicle camera mounted on a transportation device such as an automobile, a railroad vehicle, a vessel, an aircraft, or an industrial robot. Additionally, the equipment EQP into which the photoelectric conversion apparatus 100 is incorporated can be applied not only to a transportation device, but also to an equipment widely using object recognition, such as an intelligent transportation system (ITS).

The equipment EQP is suitable for an electronic device such as an information terminal having an imaging function (e.g., a smartphone or a wearable terminal) or a camera (e.g., an interchangeable lens camera, a compact camera, a video camera, or a monitoring camera). The equipment EQP can also be a transportation device such as a vehicle, a vessel, or an aircraft. The equipment EQP as the transportation device is suitable for a transportation device that transports the photoelectric conversion apparatus 100, or a transportation device that assists and/or automates driving (maneuvering) by an imaging function. The processing apparatus PRCS for assisting and/or automating driving (maneuvering) can perform processing for operating the machine apparatus MCHN as a moving device based on information obtained by the photoelectric conversion apparatus 100. Alternatively, the equipment EQP may be a medical device such as an endoscope, a measurement device such as a distance measurement sensor, an analysis device such as an electron microscope, an office device such as a copying machine, or an industrial device such as a robot.

According to the above exemplary embodiments, it is possible to provide a technique advantageous in reducing a multiplication factor. Thus, if the photoelectric conversion apparatus 100 according to the present exemplary embodiments is used in the equipment EQP, it is also possible to improve the value of the equipment.

The disclosure is not limited to the above exemplary embodiments, and can be changed and modified in various ways without departing from the spirit and the scope of the disclosure. Thus, the claims are appended to publicize the scope of the aspect of the embodiments.

The disclosure of the specification includes the following photoelectric conversion apparatus and equipment.

### (Item 1)

A photoelectric conversion apparatus in which a photoelectric conversion unit is disposed on a semiconductor substrate including a first main surface and a second main surface on the opposite side of the first main surface,
the photoelectric conversion unit comprising:
a first region of a first conductivity type constituting a part of the first main surface and connected to a detection circuit configured to detect avalanche breakdown;
a second region of the first conductivity type disposed away from the first region;
a third region of a second conductivity type opposite to the first conductivity type, the third region disposed at a position closer to the second main surface than the first and second regions; and
a fourth region disposed between the first and second regions,
wherein the second and third regions function as an avalanche photodiode, and
wherein the first and second regions are configured to be conductive with each other via the fourth region.

### (Item 2)

The photoelectric conversion apparatus according to item 1, wherein the first and third regions do not function as an avalanche photodiode.

### (Item 3)

The photoelectric conversion apparatus according to item 1 or 2, wherein a distance between the second and third regions is shorter than a distance between the first and third regions.

### (Item 4)

A photoelectric conversion apparatus in which a photoelectric conversion unit is disposed on a semiconductor substrate including a first main surface and a second main surface on the opposite side of the first main surface,
the photoelectric conversion unit comprising:
a first region of a first conductivity type constituting a part of the first main surface and connected to a detection circuit configured to detect avalanche breakdown;
a second region of the first conductivity type disposed away from the first region;
a third region of a second conductivity type opposite to the first conductivity type, the third region disposed at a position closer to the second main surface than the first and second regions; and
a fourth region disposed to connect the first and second regions,
wherein a distance between the second and third regions is shorter than a distance between the first and third regions.

### (Item 5)

The photoelectric conversion apparatus according to any one of items 1 to 4, wherein an impurity concentration of the fourth region is lower than impurity concentrations of the first and second regions.

### (Item 6)

The photoelectric conversion apparatus according to any one of items 1 to 5,
wherein the photoelectric conversion unit further comprises a fifth region having a lower impurity concentration than impurity concentrations of the first and second regions, between the third region and the second main surface, and
wherein a charge generated in the fifth region by incidence of light flows into the second region through a depletion region formed in a region in the third region that overlaps the second region in orthogonal projection onto the first main surface.

### (Item 7)

The photoelectric conversion apparatus according to any one of items 1 to 6, wherein the fourth region includes a region of the first conductivity type.

### (Item 8)

The photoelectric conversion apparatus according to item 7, wherein the fourth region functions as a resistor connecting the first and second regions.

### (Item 9)

The photoelectric conversion apparatus according to item 8, wherein the fourth region functions as a resistor of 20 kΩ or more.

### (Item 10)

The photoelectric conversion apparatus according to any one of items 1 to 9, wherein the second region constitutes a part of the first main surface.

### (Item 11)

The photoelectric conversion apparatus according to any one of items 1 to 9, wherein the second region is disposed between the first and third regions.

### (Item 12)

The photoelectric conversion apparatus according to any one of items 1 to 11, wherein the photoelectric conversion unit further comprises a setting circuit configured to, in a case where the detection circuit detects avalanche breakdown, set potentials of the first and second regions to a potential at which avalanche breakdown does not occur in the photoelectric conversion unit.

### (Item 13)

The photoelectric conversion apparatus according to any one of items 1 to 12, wherein the photoelectric conversion unit further comprises a reset circuit configured to reset potentials of the first and second regions to a predetermined potential.

### (Item 14)

The photoelectric conversion apparatus according to any one of items 1 to 6,
wherein the second region constitutes a part of the first main surface,
wherein the photoelectric conversion unit further comprises a transistor configured to cause each of the first and second regions to function as a source region or a drain region and configured to cause the fourth region to function as a channel region, and
wherein the transistor controls conduction between the first and second regions.

### (Item 15)

The photoelectric conversion apparatus according to item 14,
wherein the photoelectric conversion unit further comprises a reset circuit configured to reset potentials of the first and second regions to a predetermined potential,
wherein the transistor becomes conductive in a predetermined cycle, and
wherein the reset circuit resets the potentials of the first and second regions in the same cycle as the cycle of the transistor.

### (Item 16)

The photoelectric conversion apparatus according to item 15, wherein the detection circuit detects avalanche breakdown according to the potential of the first region in a case where the transistor becomes conductive.

### (Item 17)

The photoelectric conversion apparatus according to item 14,
wherein the photoelectric conversion unit further comprises a reset circuit configured to reset potentials of the first and second regions to a predetermined potential,
wherein the transistor becomes conductive in a predetermined cycle, and
wherein every time the transistor becomes conductive a predetermined number of times, the reset circuit resets the potentials of the first and second regions.

### (Item 18)

The photoelectric conversion apparatus according to item 17, wherein before the transistor becomes conductive the predetermined number of times and the reset circuit resets the potentials of the first and second regions, the detection circuit generates a digital signal according to the potential of the first region.

### (Item 19)

The photoelectric conversion apparatus according to any one of items 15 to 18, wherein the reset circuit starts resetting the potentials of the first and second regions while the transistor is conductive.

### (Item 20)

The photoelectric conversion apparatus according to item 11, wherein the photoelectric conversion unit further comprises a sixth region of the second conductivity type at least including a region overlapping the first and second regions in a planar view, the sixth region being disposed at a depth between the first and second regions.

### (Item 21)

The photoelectric conversion apparatus according to item 20, wherein the fourth region is surrounded by the sixth region in the planar view, has almost the same depth as the depth of the sixth region, and is a region having a lower impurity concentration of the second conductivity type than an impurity concentration of the sixth region or is a region of the first conductivity type.

### (Item 22)

An equipment comprising:
the photoelectric conversion apparatus according to any one of items 1 to 21; and
a processing apparatus configured to process a signal output from the photoelectric conversion apparatus.

According to the present invention, it is possible to provide a technique advantageous in reducing a multiplication factor.

While the disclosure has been described with reference to exemplary embodiments, it is to be understood that the disclosure is not limited to the disclosed exemplary embodiments. The scope of the following claims is to be accorded the broadest interpretation so as to encompass all such modifications and equivalent structures and functions.

## Claims

1. An apparatus in which a photoelectric conversion unit is disposed on a semiconductor substrate including a first surface and a second surface on the opposite side of the first surface,
the photoelectric conversion unit comprising:
a first region of a first conductivity type constituting a part of the first surface and connected to a detection circuit configured to detect avalanche breakdown;
a second region of the first conductivity type disposed away from the first region;
a third region of a second conductivity type opposite to the first conductivity type, the third region disposed at a position closer to the second surface than the first and second regions; and
a fourth region disposed between the first and second regions,
wherein the second and third regions function as an avalanche photodiode, and
wherein the first and second regions are configured to be conductive with each other via the fourth region.

2. The apparatus according to claim 1, wherein the first and third regions do not function as an avalanche photodiode.

3. The apparatus according to claim 1 or 2, wherein a distance between the second and third regions is shorter than a distance between the first and third regions.

4. An apparatus in which a photoelectric conversion unit is disposed on a semiconductor substrate including a first surface and a second surface on the opposite side of the first surface,
the photoelectric conversion unit comprising:
a first region of a first conductivity type constituting a part of the first surface and connected to a detection circuit configured to detect avalanche breakdown;
a second region of the first conductivity type disposed away from the first region;
a third region of a second conductivity type opposite to the first conductivity type, the third region disposed at a position closer to the second surface than the first and second regions; and
a fourth region disposed to connect the first and second regions,
wherein a distance between the second and third regions is shorter than a distance between the first and third regions.

5. The apparatus according to any one of claims 1 to 4, wherein an impurity concentration of the fourth region is lower than impurity concentrations of the first and second regions.

6. The apparatus according to any one of claims 1 to 5,
wherein the photoelectric conversion unit further comprises a fifth region having a lower impurity concentration than impurity concentrations of the first and second regions, between the third region and the second surface, and
wherein a charge generated in the fifth region by incidence of light flows into the second region through a depletion region formed in a region in the third region that overlaps the second region in orthogonal projection onto the first surface.

7. The apparatus according to claim 6, wherein the fourth region includes a region of the first conductivity type.

8. The apparatus according to any one of claims 1 to 6, wherein the fourth region functions as a resistor connecting the first and second regions.

9. The apparatus according to claim 8, wherein the fourth region functions as a resistor of 20 kΩ or more.

10. The apparatus according to any one of claims 1 to 9, wherein the second region constitutes a part of the first surface.

11. The apparatus according to any one of claims 1 to 10, wherein the second region is disposed between the first and third regions.

12. The apparatus according to any one of claim 1 to 11, wherein the photoelectric conversion unit further comprises a setting circuit configured to, in a case where the detection circuit detects avalanche breakdown, set potentials of the first and second regions to a potential at which avalanche breakdown does not occur in the photoelectric conversion unit.

13. The apparatus according to any one of claims 1 to 12, wherein the photoelectric conversion unit further comprises a reset circuit configured to reset potentials of the first and second regions to a predetermined potential.

14. The apparatus according to any one of claim 1 to 10,
wherein the second region constitutes a part of the first surface,
wherein the photoelectric conversion unit further comprises a transistor configured to cause each of the first and second regions to function as a source region or a drain region and configured to cause the fourth region to function as a channel region, and
wherein the transistor controls conduction between the first and second regions.

15. The apparatus according to claim 14,
wherein the photoelectric conversion unit further comprises a reset circuit configured to reset potentials of the first and second regions to a predetermined potential,
wherein the transistor becomes conductive in a predetermined cycle, and
wherein the reset circuit resets the potentials of the first and second regions in the same cycle as the cycle of the transistor.

16. The apparatus according to claim 15, wherein the detection circuit detects avalanche breakdown according to the potential of the first region in a case where the transistor becomes conductive.

17. The apparatus according to claim 14,
wherein the photoelectric conversion unit further comprises a reset circuit configured to reset potentials of the first and second regions to a predetermined potential,
wherein the transistor becomes conductive in a predetermined cycle, and
wherein every time the transistor becomes conductive a predetermined number of times, the reset circuit resets the potentials of the first and second regions.

18. The apparatus according to claim 17, wherein before the transistor becomes conductive the predetermined number of times and the reset circuit resets the potentials of the first and second regions, the detection circuit generates a digital signal according to the potential of the first region.

19. The apparatus according to any one of claims 15 to 18, wherein the reset circuit starts resetting the potentials of the first and second regions while the transistor is conductive.

20. The apparatus according to claim 11, wherein the photoelectric conversion unit further comprises a sixth region of the second conductivity type at least including a region overlapping the first and second regions in a planar view, the sixth region being disposed at a depth between the first and second regions.

21. The apparatus according to claim 20, wherein the fourth region is surrounded by the sixth region in the planar view, has almost the same depth as the depth of the sixth region, and is a region having a lower impurity concentration of the second conductivity type than an impurity concentration of the sixth region or is a region of the first conductivity type.

22. An equipment comprising:
the apparatus according to any one of claims 1 to 21; and
a processing apparatus configured to process a signal output from the apparatus.
